(19) Europäisches Patentamt / European Patent Office / Office européen des brevets

(11) **EP 4 312 152 B1**

(12) **EUROPEAN PATENT SPECIFICATION**

(45) Date of publication and mention
of the grant of the patent:
**21.01.2026 Bulletin 2026/04**

(21) Application number: **22306107.8**

(22) Date of filing: **25.07.2022**

(51) International Patent Classification (IPC):
$G06N\ 3/08^{(2023.01)}$       $G06N\ 20/00^{(2019.01)}$
$G06F\ 18/24^{(2023.01)}$      $G06N\ 3/09^{(2023.01)}$

(52) Cooperative Patent Classification (CPC):
**G06N 20/00; G06F 18/24; G06N 3/09**

(54) **MATERIAL SELECTION FOR DESIGNING A MANUFACTURING PRODUCT**

MATERIALAUSWAHL ZUM ENTWURF EINES FERTIGUNGSERZEUGNISSES

SÉLECTION DE MATÉRIAU POUR LA CONCEPTION D'UN PRODUIT DE FABRICATION

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(43) Date of publication of application:
**31.01.2024 Bulletin 2024/05**

(73) Proprietor: **Dassault Systèmes**
**78140 Vélizy-Villacoublay (FR)**

(72) Inventors:
• **TLILI, Ali**
**Vélizy-Villacoublay (FR)**
• **KHALED, Oumaima**
**Vélizy-Villacoublay (FR)**

(74) Representative: **Bandpay & Greuter**
**11 rue Christophe Colomb**
**75008 Paris (FR)**

(56) References cited:
• IPEK M�MTAZ ET AL: "An expert system based material selection approach to manufacturing", MATERIALS AND DESIGN, LONDON, GB, vol. 47, 14 December 2012 (2012-12-14), pages 331 - 340, XP028984324, ISSN: 0261-3069, DOI: 10.1016/ J.MATDES.2012.11.060
• PEGDWENDE MINOUNGOU ET AL: "Learning MR-Sort Models from Non-Monotone Data", ARXIV.ORG, CORNELL UNIVERSITY LIBRARY, 201 OLIN LIBRARY CORNELL UNIVERSITY ITHACA, NY 14853, 20 July 2021 (2021-07-20), XP091014307
• TLILI ALI ET AL: "Learning non-compensatory sorting models using efficient SAT/MaxSAT formulations", EUROPEAN JOURNAL OF OPERATIONAL RESEARCH, ELSEVIER, AMSTERDAM, NL, vol. 298, no. 3, 19 August 2021 (2021-08-19), pages 979 - 1006, XP086916305, ISSN: 0377-2217, [retrieved on 20210819], DOI: 10.1016/J.EJOR.2021.08.017

## Description

### TECHNICAL FIELD

The disclosure relates to the field of computer programs and systems, and more specifically to a method, system and program for designing a manufacturing product.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service. <Insert page 1a>

There is however still a need for improved solutions for designing a manufacturing product.

### SUMMARY

<The invention is defined by the appended claims.>

Also known is M. Ipek et. al., "An expert system based material selection approach to manufacturing", Materials and Design 47 (2013) 331-340. This document discloses a method to solve the materials selection problem by means of an expert system approach to manufacturing. According to this method either four or five different properties are inspected for each automotive part such as impact resistance, lightness, formability, corrosion resistance and low prices for bumpers; strength, formability, vibration absorption and low cost for flywheels; and strength, formability, corrosion resistance, biocompatibility and a small price for implants.

Also known is A. Tlili et. al., "Learning non-compensatory sorting models using efficient SAT /MaxSAT formulations", European Journal of Operational Research. This document discusses two popular variants of the Non-Compensatory Sorting model are considered, the Non-Compensatory Sorting model with a unique profile and the Non-Compensatory Sorting model with a unique set of sufficient coalitions. For each variant, the document starts by extending the formulation based on a separation principle to the multiple category case. Moreover, the document extends the two formulations to handle inconsistency in the preference information using the Maximum satisfiability problem language. A computational study is proposed to compare the efficiency of both formulations to learn the two Non-Compensatory Sorting models (with a unique profile and with a unique set of sufficient coalitions) from noiseless and noisy preference information.

Also known is p. Minoungou et. al., "Learning MR-Sort Models from Non-Monotone Data", arXiv:2107.09668v1, 20 Jul 2021. This document discusses the Majority Rule Sorting (MR-Sort) method, which assigns alternatives evaluated on multiple criteria to one of the predefined ordered categories. The Inverse MR-Sort problem (Inv-MR-Sort) computes MR-Sort parameters that match a dataset. Existing learning algorithms for Inv-MR-Sort consider monotone preferences on criteria. The document extends this problem to the case where the preferences on criteria are not necessarily monotone, but possibly single-peaked (or single-valley). It is proposed a mixed-integer programming based algorithm that learns the preferences on criteria together with the other MR-Sort parameters from the training data. The document investigates the performance of the algorithm using numerical experiments and we illustrate its use on a real-world case study.

### BRIEF DESCRIPTION OF THE DRAWINGS

Non-limiting examples will now be described in reference to the accompanying drawings, where:

- FIG.s 1 to 13 illustrate the method; and

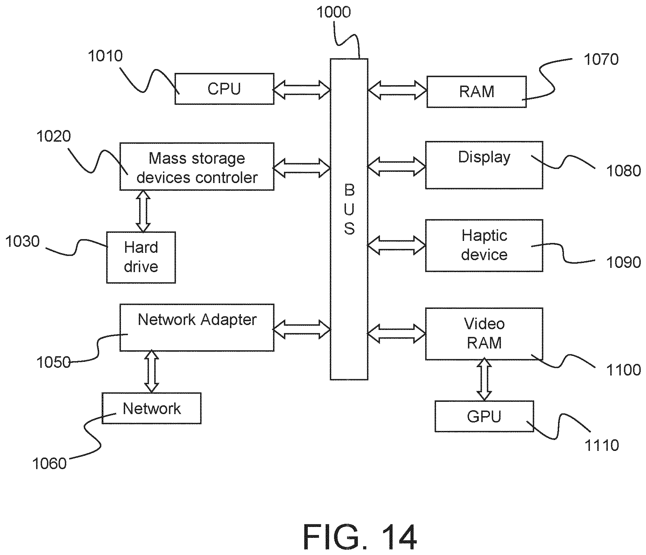

- FIG. 14 shows an example of the system.

## DETAILED DESCRIPTION

It is proposed a computer-implemented method for designing a manufacturing product. The method comprises providing a set of materials for manufacturing the product. The method further comprises providing a set of use and/or manufacturing constraints for the manufacturing product. The method further comprises providing specifications indicating an extent of compatibility of one or more reference materials with the constraints. The method further comprises determining an optimal subset of the set of materials for manufacturing the product. The determining includes classifying the materials with respect to compatibility with the constraints and based on the provided specifications.

This constitutes an improved solution for designing a manufacturing product.

Notably, given an input set of materials (i.e. the provided set of materials) and constraints (i.e. the provided use and/or manufacturing constraints for manufacturing the product), the method outputs a subset (i.e. the optimal subset) of the input set of materials which is (or at least tend to be) optimal for manufacturing the product under the constraints. The output subset is made of optimal materials for manufacturing the product. This means that the subset comprises the best material(s), within the input set, for manufacturing the product given the constraints. The output subset may for example include a list of such materials each with a score indicating an extent of optimality of the material with respect to the provided constraints. In other words, the method allows to, given a set of materials, determine a subset thereof for manufacturing a product, the subset being optimal for manufacturing the product given the provided constraints.

The constraints capture (i.e. describe, represent) constraints to which the product is subject during use (captured by the use constraints) and/or constraints for manufacturing the product (captured by the manufacturing constraints). Thus, there are materials which are compatible with the constraints, e.g. materials compatible with a manufacturing process for manufacturing the product or materials adapted for a given use of the product, and materials which are not, and materials which are compatible with the constraint, but only to some extent (e.g. a material compatible with a certain manufacturing process and/or with a certain use but not in a perfect manner, and/or only in combination with one or more other materials). The method finds, within the provided materials, the subset of materials, which is altogether optimal for manufacturing the constraints by classifying the materials with respect to their compatibility with the constraints. Thereby, the method classifies/sorts the materials with respect to their compatibility with the constraints so as to find the set of materials which, given these constraints, have altogether the best classification for manufacturing the product.

Finding the optimal set given the constraints, that is finding the best materials to meet the constraints, may in practice be complicated or even infeasible for the user/designer. Such selection problem may indeed in practice depend on many parameters (e.g. best theoretical material vs material availability in practice, compatibility of materials with the available manufacturing machines), and thus may require to perform an extensive objective classification task which is not feasible by hand or mentally. The method however objectively finds this optimal set through an objective classification of the materials with respect to compatibility with the constraints, and thereby credibly and objectively assists the designer for selecting the appropriate materials for manufacturing the product given the constraints.

Furthermore, the determination of the optimal subset is based on the provided specifications, which indicate an extent of compatibility of one or more reference materials with the constraints. In other words, the provided specifications guide the determination of the optimal subset by providing reference data regarding the materials and constraints compatibility. This allows a user, or several users, e.g. the designer(s)/engineer(s) that work on the product, to provide their specifications, thereby feeding the method with data about their manufacturing and/or use objective in terms of material selection. The method then determines an optimal subset that meets at least to some extent these user-provided inputs. The method thus provides a solution to objectively and credibly assist and guide a designer or a group of designers through the material selection problem for manufacturing the product.

The output of the method is the optimal subset. For example, it may consist in a list of one or more materials determined by the method as optimal for manufacturing the product with respect to compatibility of the constraints, e.g. as a list of these one or more materials. The method classifies the materials of the provided set of materials for finding the optimal subset, for example into categories of compatibility with the constraint (e.g. categories "excellent", "good", "very good", or "poor"), and the method may for example output as the optimal subset the material(s) being classified in the best compatibility category. The subset outputted by the method thus allows the designer(s)/engineers to select one or more materials within the subset for manufacturing the part, the method guaranteeing that the selected materials allow manufacturing of the part with optimal compatibility with the constraints. The designer/engineer may for example combine several materials of the optimal subset for the manufacturing, and/or select materials, which are available at the moment or with the shortest availability time. The optimal subset may in examples consist in a single material determined as being optimal by the method.

The output of the method is thus data describing the optimal material(s) for manufacturing the product under the constraints. This output thus forms the basis of an implied further use of the output, which is the real-world manufacturing of the product using one or more material(s) selected from the optimal set. The method may thus form a manufacturing process of the manufacturing product or may be included in such a process. The method may notably comprise selecting one or more materials within the optimal set of materials, and using the selected materials for manufacturing the product.

Using the selected materials for manufacturing the product designates any actions or series of actions that is/are involved in/participate to the manufacturing of the product. Using the selected material for manufacturing the product may comprise one or more of the following:

- selecting one or more manufacturing processes and/or one or more manufacturing machines suited for manufacturing the product using the selected material(s);
- performing one or more simulations of the product while accounting for the selected material(s), to test the performances of the product manufacturing with the selected material(s) (e.g. structural simulations, thermodynamics simulation);
- creating a CAM (computer-aided manufacturing) file for manufacturing the product, the CAM file including specifications of the selected material(s); and/or
- manufacturing the product using the selected material(s), for example by automatically feeding the CAM file to one or more suitable manufacturing machines.

The method is for designing a manufacturing product. Designing a manufacturing product designates any action or series of actions, which is at least a part of a process of elaborating the product. In the case of the method, the method forms a step of material selection for selecting the material(s) for manufacturing the product.

Materials selection relates to the selection of the most appropriate materials for engineering applications and manufacturing. It is a crucial function in the design and development of products. Indeed, several dimensions of the design problem are influenced by the used materials including the product central function, the customer satisfaction, the production systems used for manufacturing, the product life cycle, who is going to use or produce it, the usability, and finally the costs (as discussed in reference Ali Jahan, Kevin L. Edwards, Marjan Bahraminasab, "Materials selection in the context of design problem-solving", Butterworth-Heinemann, 2016, Pages 25-40). Materials selection can be carried out either to choose alternative materials for changes to the design of an existing product in order to reduce for example cost or weight, meet new legal requirements, overcome failure occurrence, and satisfy different market demands or to choose materials for the design of a completely new product. As stated in reference Jahan, Ali, and Kevin L Edwards, "Multi-Criteria Decision Analysis for Supporting the Selection of Engineering Materials in Product Design", Oxford: Elsevier Science & Technology, 2013, Web, it has been estimated that the relative cost of a design change after manufacture is 10,000 times more than at the conceptual stage of design, thus, an intelligent decision support tool such as the method of the present disclosure is relevant for materials selection in order to reduce costs. Material selection within the product design process is either cost driven or performance driven. In the case of the method, it is performance-driven, but the economics can additionally be contemplated as discussed hereinafter. For example, a performance-driven could be a bespoke biomedical prosthesis/ implant or a tennis racquet and an example of cost-driven could be a mass-produced motorcar or beverage can/bottle.

The method comprises providing, as inputs to the method, the set of materials, the set of constraints, and the specifications indicating an extent of compatibility of one or more reference materials with the constraints. These inputs are now discussed.

The provided set of materials is a set that comprises at least one or more materials suited for manufacturing the product. The set of materials may comprise available and/or usable materials for a factory in charge with the manufacturing of the product and/or materials known to the designer(s)/engineer(s) using the method and/or other materials known in the industry (for example stemming from a material database). The set of materials may be a list of materials, e.g. a numbered list of materials. The set of materials may be provided by one or more users, e.g. one or more designers/engineers using the method. Providing the set of materials may for example comprise, by the user(s), selecting the materials in a material database. The method may alternatively provide automatically a fixed (non-modifiable) set of materials, e.g. that stems from a material database. Providing the set of materials may comprise, providing, for each material and each constraints, a score of the material on the constraints. This may be done by one or more users, or the materials may be provided automatically with these scores fixed and non-modifiable (e.g. the scores may stem from a material database). The provided set of materials may be a large dataset. As mentioned in references Dieter, G.E., 1997, "Overview of the Materials Selection Process", ASM Metals Handbook, Materials Selection and Design. ASM International, Materials Park, OH, and Jahan, Ali & Edwards, Kevin & Bahraminasab, Marjan, (2016), "The importance of decision support in materials selection", 10.1016/B978-0-08-100536-1.00001-1, there are an enormous number of materials available, each with a range of different properties and behaviors. In case where a user oriented support system is provided, a real time selection is demanding, which makes the computation time demanding.

The set of constraints include use constraints and/or manufacturing constraints. A use constraint is a constraint during use of the material once fabricated, such as a certain required stiffness, or a certain required heat conduction capacity. A manufacturing constraint is a constraint on the material for manufacturing the product, such as a certain ability to be bent or a certain drying time. The set of constraints may further include one or more economic constraints. The constraints may also be referred to as "attributes". The set of constraints may be divided into rigid constraints, which necessarily have to be met by the optimal materials, and soft constraints, which do not have to be necessarily met by the optimal materials. The method may determine the optimal materials by requiring satisfaction of the rigid constraints and by maximizing satisfaction of the soft constraints. Each constraint may be a encoded as a string or as a number. The set of constraints may further include economic constraints. Alternatively, the set of constraints may consist in only the use constraints and/or the manufacturing constraints.

One or more constraints may be latent constraints. This means that the method does not know in advance whether such a constraint is to be maximized, minimized, or minimized below or above a peak, or maximized above or below a peak. The latent constraints may include constraints of one or more of the following three types of latent constraints (also referred to as latent requirements preferences): monotonous latent constraints, single-peaked constraints, and single-valley constraints. Monotone latent constraint is the case where the preference directions (maximization or minimization) on the constraint are not known (e.g. optical properties). Single-peaked constraint is interpreted as a constraint to be maximized bellow a peak $\alpha$ and as a constraint to be minimized above the peak $\alpha$. Single-valley constraint can be interpreted as a constraint to be minimized bellow a peak $\beta$ and as a constraint to be maximized above the peak (e.g. thermal and radiation properties). The method handles the latent constraints through the classification using the provided specifications: the method finds from the provided specifications and while finding the classification, and for each latent constraint, whether the constraint is to be maximized, minimized, or minimized below or above a peak, or maximized above or below a peak. The method may for that learn one or more NCS models as discussed hereinafter, wherein the method learns the specificities of the latent constraints while the method learns the parameters of the NCS model(s).

The set of constraints may include numerical constraints, which express the absolute measure of a material property. Examples of numerical requirements are density, modulus, strength and thermal conductivity. The set of constraints may additionally or alternatively include nonnumerical constraints, which regroup material properties that are not expressed numerically such that resistance to corrosion which can be represented as linguistic variable (e.g., poor, adequate, good). The method thus handles both constraints.

The set of constraints may be provided by one or more users of the method, *e.g.* one or more designers or engineering. For example, the use(s) may select the provided constraints by graphical interaction with a displayed list of constraints, for example by checking (*e.g.* with a mouse click or a touch) displayed checkboxes each corresponding to a respective constraints. This may include selecting one or more latent constraints, *i.e.* constraints selected without knowing whether they are to be minimized or maximized for example. The method may comprise, further to the providing of the constraints, displaying the evaluations/scores of the materials on the provided constraints, for example as an array-like display of all the scores, with the materials as lines (resp. columns) and the constraints as columns (resp. lines).

The inputs also include the specifications. The specifications indicate an extent of compatibility of one or more reference materials with the constraints. The specifications thus form data indicating how compatible is each reference material with the constraints. The specifications may comprise for example a list of the reference materials, and for each material, a score/classification of compatibility with the constraints, for example among the scores/classifications "Poor", "Good", "Very Good" and "Excellent". Each score/classification may be a string representation of one of these scores "Poor", "Good", "Very Good" and "Excellent", such as a letter representing one of these categories (for example, *Poor = C*$^1$, *Good = C*$^2$, *Very good = C*$^3$ and *Excellent = C*$^4$). The specifications may alternatively comprise solely a list of one or more reference materials considered as compatible with the constraints. The specifications may be provided by one or more users, e.g. one or more designers/engineers using the method. This allows a user, or more, to guide the method towards the determination of an optimal subset that meets or tends to meet, or at least accounts for, their expertise regarding compatibility with the constraints and regarding the manufacturing. This guides the method towards achieving an even more meaningful result, and thus makes the method in the meantime a solution to credibly assist and guide the user(s) for material selection for manufacturing: the method responds to the user specifications by providing an optimal subset that accounts for their expertise. The user(s) may also thereby react to what the method provides, and then provide different input specifications to get a different results that is more suited to their technical expertise and expectations. The method thus forms a solution for a continuous and guided user-machine interaction process for assisting the user in the material selection problem for product manufacturing.

Further to the providing of the inputs, the method comprises determining an optimal subset of materials. This is now discussed.

The optimal subset is the output of the determining, and consists in materials for manufacturing the product and identified as optimal with respect to compatibility with the provided constraints, accounting for the provided specifications. The determining of the optimal subset includes classifying the materials (*i.e.* of the provided set of materials) with respect to compatibility with the constraints. This may comprise assigning each material to one of the categories "Poor", "Good", "Very Good" and "Excellent" which have been previously discussed. The output optimal subset may for example consist in the materials classified as "Excellent", or as "Excellent" or "Very Good", or as "Excellent" or "Very Good" or "Good". As previously discussed, this classification is based on the provided specifications. This means that the classifications sorts the materials while accounting for the provided specifications. The classification may for example process the previously provided scores/classifications of each material on each constraints to classify the materials, using for example the provided specifications as a model to be learned from. The specifications may for example concern one or more material which are also in the provided set of materials, which guides the classification. Processing the score and using the specifications allows the method to understand which scores on which constraints provide for which classification, *e.g.* "Poor", "Good", "Very Good" or "Excellent. The output subset may in some cases comprise a single material, and in other cases, several materials.

The determining of the optimal subset may be carried out automatically, further to the providing of the inputs. For example, the user(s) using the method may, further to the providing of the input, launch the automatic determining of the optimal subset, *e.g.* by clicking on or touching a displayed icon adapted for this launch.

In examples, the classification comprises learning a Multiple Criteria Decision Aiding sorting model. This model is configured to take as input a set of materials and to output an optimal subset of materials. The learning is based on the set of materials, on the constraints, and on the specifications. The concept of Multiple Criteria Decision Aiding sorting model is known *per se.* The sorting model comprises parameters which are inferred through the learning. The learning in other words comprises inferring the parameters, this inference being the result of the classification. In other words, the learning infers the parameters through the classification that is done for determining the optimal set, where the specifications guide the learning. The model, once learnt, is configured to take as input a set of materials and to output the optimal subset of materials for manufacturing the part.

Multi-criteria decision-Aiding (MCDA) aims at developing decision-support models explicitly based on the construction of a set of criteria reflecting the relevant aspects of the decision-making problem. These $n$ criteria ($N = \{1, 2 ..., n\}$ with $n \geq 2$) evaluate a set of alternatives $A = \{a, b, c, ...\}$ under consideration with respect to different viewpoints. The purpose of MCDA methodologies is to support the decision maker (DM) by providing methods and frameworks to take decisions regarding the considered decision situation. Decision problems considered in MCDA are of different types and three reference problems are encountered in practice (as discussed in reference B. Roy, "Multicriteria Methodology for Decision Aiding", Kluwer Academic, Dordrecht, 1996):

- Choice problem: It consists of selecting an alternative or a subset of alternatives. A familiar MCDA choice problem is the supplier selection problem (as discussed in reference M. Khalilzadeh, A. Karami, and Alborz Hajikhani, "The multi-objective supplier selection problem with fuzzy parameters and solving the order allocation problem with coverage", Journal of Modelling in Management, 15:705-725, 2020). Indeed, suppliers are evaluated according to several criteria such as the costs, the quality and the on-time delivery and the purpose is to choose a supplier (the best one) from a list of candidates;

- Ranking problem: It consists in ordering a set of alternatives from the best to the worst according to the DM's preferences. The outcome of a ranking method can be either a partial or a complete ranking of the set of alternatives. An interesting example of the ranking problem is the selection of an information system evaluated according to several criteria for companies, as discussed in reference Ana Paula Henriques de Gusmão and C. Medeiros, "A model for selecting a strategic information system using the fitradeoff', Mathematical Problems in Engineering, 2016:1-7, 2016;

- Sorting problem: It consists in assigning each alternative to a category selected among a set of predefined and ordered categories. The outcome of a sorting method is an assignment of the alternatives among the different categories. For example, a committee of doctors makes the decision whether a patient is accepted for surgery or not by considering several criteria that assess the patient's physical health state, as discussed in reference O. Sobrie, M. E. A. Lazouni, S. Mahmoudi, V. Mousseau, and M. Pirlot, "A new decision support model for preanesthetic evaluation", Computer Methods and Programs in Biomedicine, 133:183-193, 2016. The MCDA model used in the present method solves a sorting/classification problem.

The specifications may form a learning set of the model, which is data that the parameters must match, or at least tend to match, when updated. In other words, the learning may comprise inferring the parameters from the specifications so that the inferred parameters are consistent with the specifications. It may be in other words said that the learning extends the specifications, since ultimately the learned model (i.e. the model with its parameter inferred) takes as input any input set of materials and outputs an optimal (i.e. with respect to compatibility with the constraints) subset that is consistent with the provided specifications (i.e. the compatibility of the materials in the optimal subset with the constraints is consistent with the compatibility classification provided by the specifications). In yet other words, the learning of the model takes as input a set of assignment examples (i.e. the specifications), and computes a sorting model that is consistent with this preference data. In yet other words, the learning learns the model parameters that match (e.g. perfectly) the assignment examples.

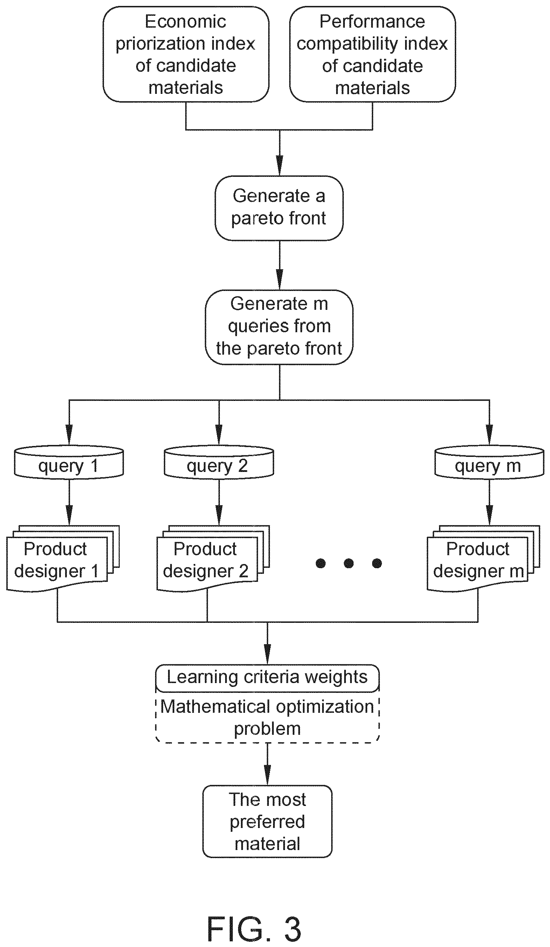

The model may include one or more Non-compensatory Sorting models, also referred to as "NCS" model. The learning of the model may thus include learning the one or more NCS models. The one or more NCS models comprise a NCS model that is learnt to take as input a set of materials and to classify these materials with respect to their compatibility with the constraints (*e.g.* into the categories poor, good, very good and excellent which have been previously discussed). This NCS model may be referred to as the "performance-driven NCS model". In other words, the NCS model outputs a classification of the materials with respect to their compatibility with the constraints. The learning of the NCS model may comprise inferring the parameters of the NCS model based on the constraints and using the specifications, so that the NCS model parameters are such that the NCS model extends the specifications as previously discussed. For example, the learning may search for parameters of the NCS model that best match the specifications. The specifications may thus form a learning set of the NCS model. In other words, the output of the model is consistent with the specifications. The one or more NCS models may in examples comprise another NCS model, that may be referred to as "the economic-driven NCS model", and that is learnt to infer an optimal set of materials with respect to the economical constraints. The economic-driven NCS model may be learnt in a similar manner than the performance-driven NCS model, but with using the economic constraints instead of the other constraints. The method may in this latter case comprise a further step, which is performing a trade-off procedure between the economic-driven NCS model and the performance-driven NCS model. The trade-off procedure is further discussed hereinafter, with reference to Program 1 hereinbelow and FIG. 3.

Learning a NCS model allows to consider interactions between the constraints, which may be dependent from each other, and allows to account for the alternative evaluations in an ordinal perspective, thereby avoiding compensation and enabling to deal meaningfully with the constraints. In real-world decision-aiding situations and in particular in the material selection problem, it is reasonable to consider the interaction between requirements/constraints since there may be requirements conflicting. The concept of NCS model is known and discussed in references Bouyssou, D., Marchant, T., "An axiomatic approach to noncompensatory sorting methods in MCDM, I: the case of two categories", European Journal of Operational Research 178(1), 217-245 (2007), and Bouyssou, D., Marchant, T., "An axiomatic approach to non-compensatory sorting methods in MCDM, II: more than two categories", European Journal of Operational Research 178(1), 246-276 (2007). NCS originates from the Electre TRI method discussed in reference Yu, W., "Aide multicritère à la décision dans le cadre de la problématique du tri: méthodes et applications", Ph.D. thesis, LAMSADE, Université Paris Dauphine, Paris (1992).

The NCS model may be formulated as follows.

Non-Compensatory Sorting (NCS) is a Multiple Criteria Decision Aiding sorting model originating from the Electre TRI method. NCS can be intuitively formulated as follows in the present case: a material is assigned to a category if:

- It is better than the lower limit of the category on a sufficiently strong subset of criteria, and
- This is not the case when comparing the alternative to the upper limit of the category.

Given the provided set of materials *A,* each material $a \in A$ is evaluated according to a finite set of properties $N$ (*i.e.* the constraints) with $n = |N|$. As previously discussed, the providing of the set of materials may comprise providing this evaluation, or the set of materials may be provided with this evaluation of the materials. Let $(a_1, a_2, ..., a_n)$ be the evaluation vector of $a \in A$ with $a_i$ denoting its evaluation on property i. Without loss of generality, the method assumes that the preference on each property increases with the evaluation. Considering a set of predefined and ordered categories $C^1 \prec \cdots \prec C^p$, multiple criteria sorting aims at assigning materials to one and only one category.

The assignment rule of the Non-Compensatory Sorting operates on two types of parameters:

- Limiting profiles $\langle b_j^h \rangle_{j \in N, h \in [2..p]}$, with $(b_1^h, ..., b_n^h)$ is the boundary between the two categories $C^{h-1}$ and $C^h$, $\forall h \in \{1, ..., p\}$. These tuples of parameters are augmented on both ends with trivial values: $(b_1^0, ..., b_n^0)$ is chosen so that it is dominated by all the alternatives and $(b_1^{p+1}, ..., b_n^{p+1})$ is chosen so that it dominates all the alternatives.

- Set of sufficient coalitions of properties $T$ required to be an upset of the power set of the properties.

The classification rule of NCS model is defined as follows:

$$\forall x \in A, \quad x \in C^h \quad \Leftrightarrow \quad \begin{cases} \{j \in N : x_j \geq b_j^h\} \in T \\ \{j \in N : x_j \geq b_j^{h+1}\} \notin T \end{cases}$$

In order to set appropriate values for the NCS preference related to parameters (limit profiles, sufficient coalitions of criteria), it may be possible to interact with the product designer and ask him directly to specify values for parameters. Instead, the method considers a learning paradigm in which a set of reference materials assignments (*i.e.* the learning set, that is the specifications) is provided, for example by the product designer(s). The aim is to extend this learning set using an NCS model. To do so, the method searches for the NCS parameters that best match the learning set. The reference materials assignments (*i.e.* the specifications) may be collected explicitly or implicitly. In the explicit mode, the method may ask the product designer to classify a subset of materials in categories $C^1 < \cdots < C^p$, and this set will constitute the learning set. In the implicit mode, the method may consider a history of examples for which previous decisions have been taken and validated by the product designer. Consequently, this history will constitute the learning set. In some situations, this learning set may be inconsistent (i.e. the product designer preferences cannot be restored by some multicriteria sorting model). To cope with this, a preliminary phase may be applied to revise the learning set, as discussed hereinafter.

The method may focus on the evaluation of materials on latent, single peaked and single valley properties. Thus, when learning the NCS model that evaluates the set of materials, the method considers these types of properties. In case of multiple product designers, the method may comprise providing, by each designer, a set of reference materials assignments $A_i^*$, which altogether form the provided specifications. The objective is to learn a collective NCS model aligned with all the product designers points of view. Putting all the learning sets together in an aggregated learning set A* can add inconsistency and therefore no NCS model can be elicited. In this case, the method may comprise, as discussed hereinafter, an interactive procedure to revise the learning set *A\** by proposing at each iteration to the product designers to agree on the assignment of a reference material among those which generate the inconsistency.

The learning may comprise encoding learning clauses based on the constraints. The encoding uses a SAT-based encoding. Using the SAT-based encoring improves efficiency of the learning (*i.e.* reduces learning time). SAT-based encoding is known *per se,* and for example discussed in reference, Belahcene, K., Labreuche, C., Maudet, N., Mousseau, V., Ouerdane, W., "An efficient SAT formulation for learning multiple criteria non-compensatory sorting rules from examples", Computers & Operations Research 97, 58-71 (2018). Mathematical Programming 1, 366-375 (1971). The encoding may comprise formulating the learning clauses by using a SAT formulation or a MaxSAT formulation, as known *per se* from SAT-based encoding.

A SAT instance is a Boolean formula that has three components; a set of variables $(x_1, x_2, ..., x_n)$, a set of literals, each literal is a variable $x$ or its negation $\neg x$, and a set of distinct clauses $(C_1, C_2, ... , C_m)$. Each clause consists of only literals combined with logical "or" (V) connectives. The goal of the satisfiability problem is to determine whether there exists an assignment of truth values to variables $(x_1, x_2, ..., x_n)$, that makes the following Conjunctive Normal Form (CNF) formula satisfiable: $C_1 \wedge C_2 \wedge ... \wedge C_m$, where $\wedge$ is a logical "and". In some situations, satisfying all the constraints is not possible. Thus the method seeks to finding an assignment to satisfy the most constraints (clauses), i.e. resolving the Maximum Satisfiability (MaxSAT) problem. Particularly, people are often interested in solving Partial MaxSAT, where the constraints are divided into hard and soft constraints. The goal is to satisfy all hard constraints and maximize the number (or the total weight) of satisfied soft constraints. To distinguish between hard and soft clauses, let $w_{max}$ be the weight associated with each hard clause and therefore, and the method considers clauses associated with a weight less than $w_{max}$ as soft clauses. Many real world problems can be modeled as MaxSAT problems naturally.

By "encoding learning clauses based on the constraints", the following is meant. The classification solves, or at least attempts to solve, a classification problem which consists in classifying the materials with respect to their compatibility with the constraints. The encoding of the learning clauses thereby consists in formulating, with a SAT formulation or MaxSAT formulation, learning clauses encoding the classification problem and the constraints.

Examples of the learning where learning clauses are encoded using a SAT-based encoding are now discussed. First, notations that will be used are now defined.

Notations:

- $m$ the number of product designers (*i.e.* number of users);
- $i \in \{1, ... , m\}$: the $i^{th}$ product designer (*i.e.* $i^{th}$ user);
- $n_{CRR}$ the number of component rigid requirements (*i.e.* rigid constraints);
- $n_{CSR}$ the number of component soft requirements (*i.e.* soft constraints);
- $n_{MPP}$ the number of materials performance properties (*i.e.* use and/or manufacturing constraints);
- $n_{MEP}$ the number of materials economic properties (*i.e.* economic constraints);
- 

$$N_P = \{1, ..., n_{CSR}, n_{CSR} + 1, ..., n_{CSR} + n_{MPP}\};$$

- $N_P = N_P^{max} \cup N_P^{min} \cup N_P^{lat} \cup N_P^{SP} \cup N_P^{SV}$, with $N_P^{max}$ the set of attributes to be maximized, $N_P^{min}$ the set of attributes to be minimized, $N_P^{lat}$ the set of latent attributes, $N_P^{SP}$ the set of single peaked attributes and $N_P^{SV}$ the set of single valley attributes;

- 

$$N_E = \{1, \dots, n_{CSR}, n_{CSR} + 1, \dots, n_{CSR} + n_{MEP}\};$$

- $N_E = N_E^{max} \cup N_E^{min} \cup N_E^{lat} \cup N_E^{SP} \cup N_E^{SV}$, with $N_E^{max}$ the set of attributes to be maximized, $N_E^{min}$ the set of attributes to be minimized, $N_E^{lat}$ the set of latent attributes, $N_E^{SP}$ the set of single peaked attributes and $N_E^{SV}$ the set of single valley attributes;

- $k_{j_P}$ the evaluation of material $k$ according to $j_P \in N_P$;
- $k_{j_E}$ the evaluation of material $k$ according to $j_E \in N_E$;
- $C_i^{*,1}, C_i^{*,2}, \dots, C_i^{*,m}$ the reference materials assignments given by the product designer i;
- A the set of candidate materials(*i.e.* the provided set of material);
- $A_i^{*P}$ learning set provided by the $i^{th}$ product designer to learn an NCS model according to materials performance properties;
- $A_i^{*E}$ learning set provided by the $i^{th}$ product designer to learn an NCS model according to materials economic properties;
- $A^{*P}$ collective learning set provided by all the product designers to learn a collective NCS model according to materials performance properties;
- $A^{*E}$ collective learning set provided by all the product designers to learn a collective NCS model according to materials economic properties;
- $suc_j(k)$ the immediate successor of $k$ according to $j$ and $pred_j(k)$ is the immediate predecessor of $k$ according to $j$.

The performance-driven evaluation model in the currently discussed examples is an NCS model that associate to each material a performance compatibility index among the set {*Poor, Good, Very good, Excellent*}. Thus, four ordered and predefined categories *Poor* $\prec$ *Good* $\prec$ Very *good* $\prec$ *Excellent* are defined and the method seeks for classifying each material to one category based on its performance properties as well as the component rigid and soft requirements. In the interests of simplification, the notations *Poor* = $C^1$, *Good* = $C^2$, *Very good* = $C^3$ and *Excellent* = $C^4$ are used.

**Variables:** Learning the performance-driven evaluation model involves 3 family of variables:

- *"a"* variables, indexed by an attribute $j \in N$, an exigence level $h \in [2,4]$ and a material $k \in A$, represent the approved sets with the following semantic: $a_{j,hk} = 1 \iff k_i \geq b_i^h$ *i.e.* $k$ is approved according to*i*;
- *"t"* variables, indexed by a collation of criteria $B \subseteq N$ represent the sufficient coalitions $T$, with the following semantic: $t_B = 1 \iff B \in T$ *i.e.* the coalition $B$ is sufficient;
- *"d"* variables, indexed by a criterion $j \in N$ represent the direction of latent criteria, with the following semantic: $d_j = 1 \iff$ the criterion $j$ is to be maximized, otherwise, the criterion $j$ is to be minimized;
- *"z"* variables, indexed by an reference material $k \in A^{*P}$, represent the set of reference materials properly classified by the inferred model;
- *"x"* variables, indexed by a candidate material $k \in A^{*P}$, represent the set candidate materials compatible with the component rigid requirements.

**Clauses:**

1. SAT clauses based on the component rigid requirements: let $k_{j_{CRR}} = 1$ if the material $k \in A$ is compatible with the component rigid requirement $j_{CRR}$ and 0, otherwise. According to this definition, SAT clauses based on the component rigid requirements are as follows:

$$\bigwedge_{j_{CSR}\in\{1,...,n_{CSR}\}}\bigwedge_{k\in A:k_{j_{CRR}}=1} x_k$$

$$\bigwedge_{j_{CSR}\in\{1,...,n_{CSR}\}}\bigwedge_{k\in A:k_{j_{CRR}}=0} \neg x_k$$

2. SAT/MaxSAT formulation for learning an NCS model based on component rigid and soft requirements and performance properties $\varphi^{NCS}$:

$\varphi_1^{NCS}$ : ensure monotony for the criteria to be maximized

$\varphi_2^{NCS}$ : ensure monotony for the criteria to be minimized

$\varphi_3^{NCS}, \varphi_4^{NCS}$ : ensure monotony for latent monotone criteria

$\varphi_5^{NCS}$ : ensure monotony for single peaked and single valley criteria

$\varphi_6^{NCS}$ : ensure the dominance relationship between the limit profiles

$\varphi_7^{NCS}$ : ensure that the set of sufficient coalitions T is an upset

$\varphi_8^{NCS}, \varphi_9^{NCS}$ : ensure the restoration of the learning set

$\varphi_{10}^{NCS}$ : ensure the maximization of the respected number of reference material assignments

$$\varphi^{NCS} = \bigwedge_{l\in\{1,11\}} \varphi_l^{NCS}$$

$$(\varphi_1^{NCS}, w_{max}) = \bigwedge_{j\in N_P^{max}, \; h\in[2,...,p]} \bigwedge_{k'\geq_j k\in A} \left(a_{j,h,k'} \vee \neg a_{j,h,k} \vee \neg x_k \vee \neg x_{k'}\right)$$

$$(\varphi_2^{NCS}, w_{max}) = \bigwedge_{j\in N_P^{min}, \; h\in[2,...,p]} \bigwedge_{k'\geq_j k\in A} \left(\neg a_{j,h,k'} \vee a_{j,h,k} \vee \neg x_k \vee \neg x_{k'}\right)$$

$$(\varphi_3^{NCS}, w_{max}) = \bigwedge_{j\in N_P^{lat}, \; h\in[2,...,p]} \bigwedge_{k'\geq_j k\in A} \left(a_{j,h,k'} \vee \neg a_{j,h,k} \vee \neg x_k \vee \neg x_{k'} \right.$$
$$\left. \vee \neg d_j\right)$$

$$(\varphi_4^{NCS}, w_{max}) = \bigwedge_{j\in N_P^{lat}, \; h\in[2,...,p]} \bigwedge_{k'\geq_j k\in A} \left(\neg a_{j,h,k'} \vee a_{j,h,k} \vee \neg x_k \vee \neg x_{k'} \right.$$
$$\left. \vee d_j\right)$$

$$(\varphi_5^{NCS}, w_{max}) = \bigwedge_{j\in N_P^{SP}, \; h\in[2,...,p]} \bigwedge_{k''\geq_j k'\geq_j k\in A} \left(a_{j,h,k'} \vee \neg a_{j,h,k} \vee \neg a_{j,h,k''} \right.$$
$$\left. \vee \neg x_k \vee \neg x_{k'} \vee \neg x_{k''}\right)$$

$$(\varphi_6^{NCS}, w_{max}) = \bigwedge_{j\in N_P^{SV},\ h\in[2,...,p]} \bigwedge_{k''\geq_j k'\geq_j k\in A} \left(a_{j,h,k'} \vee \neg a_{j,h,k} \vee \neg a_{j,h,k''}\right.$$
$$\left. \vee \neg x_k \vee \neg x_{k'} \vee \neg x_{k''}\right)$$

$$(\varphi_7^{NCS}, w_{max}) = \bigwedge_{j\in N_P,\ h<h'\in[2,...,p],\ k\in A} \left(a_{j,h,k} \vee \neg a_{j,h',k} \vee \neg x_k\right)$$

$$(\varphi_8^{NCS}, w_{max}) = \bigwedge_{B\subset B'\subseteq N_P,\ h\in[2,...,p]} \left(t_{B'} \vee \neg t_B \vee \neg x_k\right)$$

$$(\varphi_9^{NCS}, w_{max}) = \bigwedge_{B\subseteq N_P,\ h\in[2,...,p]} \bigwedge_{k\in C^{*,h-1}} \left(\bigvee_{j\in B} \neg a_{j,h,k} \vee \neg t_B \vee \neg z_k \vee \neg x_k\right)$$

$$(\varphi_{10}^{NCS}, w_{max}) = \bigwedge_{B\subseteq N_P,\ h\in[2,...,p]} \bigwedge_{k\in C^{*,h}} \left(\bigvee_{j\in B} a_{j,h,k} \vee t_{N\setminus B} \vee \neg z_k \vee \neg x_k\right)$$

$$(\varphi_{11}^{NCS}, w_1) = \bigwedge_{k\in A^{*P}} (z\_k)$$

$\varphi_{i\in\{1,...,10\}}^{NCS}$ are hard, associated to the weight $w_{max}$ and the weight $w_1$ is associated to $\varphi_{11}^{NCS}$ such as $w_{max}\geq |A^{*P}|$.

The specifications may comprise incompatible specifications. The incompatible specifications may be provided by different users, *e.g.* different expert designers. The learning includes in this case finding a compromise between the incompatible specifications. This may comprise encoding learning clauses based on the constraints, the encoding using in this case a MaxSAT-based encoding, as discussed for example in the above-discussed examples. The MaxSAT-based encoding allows to learn the NCS model despite the incompatible classifications. Additionally or alternatively, finding a compromise may comprise iteratively modifying the learning set until reaching an extent of compatibility between the specifications. This iterative modification may comprise:

- determining material of which classifications according to the provided specifications are not respected by the learnt model;
- among the determined material, selecting the material for which a largest number of specifications are not respected, and assigning a classification to this material. Assigning the classification may comprise asking each user to provide the classification and use a voting rule to select one of the user's provided classification (as discussed hereinafter);
- modifying the provided specifications to add the determined material's new assignment;
- re-learning the NCS model based on the modified specifications (*e.g.* using the SAT/MaxSAT formulation $\varphi^{NCS}$), and test the consistency of the modified specifications;
- if the modified specifications are consistent (*i.e.* there are no non-compatible specifications anymore), returning the model, otherwise returning to the first step;

Examples of the finding of the compromise between the incompatible specifications are now discussed.

In these examples, there are multiple product designers. The method learns in these examples the NCS model from $A^{*P} = \bigcup_{i\in\{1,...,m\}} A_i^{*P}$, where $A_i^{*P}$ is the learning set provided by the $i^{th}$ product designer. $A^{*P}$ thus forms the provided set of specifications. In case where the collective learning set $A^{*P}$ is inconsistent, the method may proceed with the following algorithm:

i. Generate all sets of unrestored reference materials assignments, *i.e.* the materials of which affectation/classification is not respected by the learnt NCS model;

ii. Evaluate each reference material in the sets of unrestored reference materials assignments with the following indicator:

$$core(x)$$

$$= \frac{number\ of\ sets\ unrestored\ reference\ materials\ assignments\ which\ contain\ x}{number\ of\ sets\ unrestored\ reference\ materials\ assignments};$$

iii. Ask each product designer to assign the reference material $\alpha$ associated with the maximum core into one of the categories *{Poor, Good, Very Good, Excellent}*;

iv. Use a voting rule to choose one assignment of $\alpha$ from all product designers' assignments: each product designer ranks the categories and associates the best category with a score of 4 and the worst category with a score of 1. Then, for each category, the overall score is computed which is the sum of the individual scores given by the product designers. Finally, assign $\alpha$ to the category with the maximum score;

v. Update the set $A^{*P}$ with the new assignment of $\alpha$;

vi. Test the satisfiability of $A^{*P}$ using the SAT/MaxSAT formulation $\varphi^{NCS}$;

vii. If $A^{*P}$ is consistant then return the learned NCS model (i.e. the profiles and the set of sufficient coalitions), otherwise, return to the first step.

Using the previous algorithm, the method thereby learns a collective NCS model which will serve to assign the set of candidate materials A into the four categories *{Poor, Good, Very good, Excellent}*. In other words, given a component, the method builds a collective performance-driven evaluation model which evaluated the set of candidate materials according to the rigid and soft component requirements and according to the materials performance properties. The resulting NCS model parameters are computed as follows:

$$T = \{B \in N^P :\ y_B = 1\}$$

$$\forall h \in \{2,3,4\}, \begin{cases} \forall j \in N_P^{max}, & b_j^h = \min\{k_j : a_{j,h,k} = 1\} \\ \forall j \in N_P^{min}, & b_j^h = \min\{k_j : a_{j,h,k} = 0\} \\ \forall j \in N_P^{lat}, & \begin{cases} if\ d_j = 1\ then\ b_j^h = \min\{k_j : a_{j,h,k} = 1\} \\ if\ d_j = 0\ then\ b_j^h = \min\{k_j : a_{j,h,k} = 0\} \end{cases} \\ \forall j \in N_P^{SP}, & \begin{cases} b_{j,min}^h = \max\{k_j : a_{j,h,k} = 0\} \\ b_{j,max}^h = \min\{k_j : a_{j,h,k} = 1\} \end{cases} \\ \forall j \in N_P^{SV}, & \begin{cases} b_{j,min}^h = \max\{k_j : (a_{j,h,k} = 1 \wedge k' = suc_j(k), a_{j,h,k'} = 0)\} \\ b_{j,max}^h = \min\{k_j : (a_{j,h,k} = 1 \wedge k' = pred_j(k), a_{j,h,k'} = 0)\} \end{cases} \end{cases}$$

FIG.s 1A to 1C show a flowchart illustrating the learning of the NCS model for multiple product designers according to the above-discussed examples.

It has been discussed examples of learning an NCS model based on the use and/or manufacturing constraints, such a model being for example referred to as "the performance-driven evaluation model". The method may further comprise learning an economic-driven evaluation model, e.g. for multiple product designers, based on further constraints which are economic constraints.

In examples, the economic-driven evaluation model is an NCS model that associates to each material an economic prioritization index among the set *{Poor, Good, Very good, Excellent}*. Thus, four ordered and predefined categories *Poor < Good < Very good < Excellent* are defined and the method seeks for classifying each material to one category based on his economic properties as well as the component rigid and soft requirements. The same procedure as in the performance-driven evaluation model may be applied to learn the economic-driven evaluation model. Regarding the formulation $\varphi^{NCS}$ the sets $N_E^{max}, N_E^{min}, N_E^{lat}, N_E^{SP}, N_E^{SV}, N_E$ and $A^{*E}$ may be used instead of

$N_P^{max}$ , $N_P^{min}$ , $N_P^{lat}$ , $N_P^{SP}$ , $N_P^{SV}$ , $N_P$ and $A^{*P}$. Moreover, the method may as previously learn a collective NCS model aligned with the product designers preferences, as illustrated on FIG.s 2A to 2C.

In examples, the method may learn both the economic-driven NCS model and the performance-driven evaluation NCS model, and may then perform a trade-off procedure between the two models to help the designer(s) for selecting a material that is optimal with respect to both economic performances and use and/or constraints performances. In these examples, the performance-driven and the economic-driven evaluations models are used to access to each material a performance compatibility index and an economic prioritization index among the indexes {*Poor, Good, Very good, Excellent*}, and therefore to partially ordered the set of candidate materials. To analyze the trade-off between both evaluations, the method may use a bi-criteria weighted sum to assist the product designers when choosing the most preferred material. For each product designer, the method arbitrarily chooses a couple of non-dominated materials, then asks the product designer to compare them. Each query defines a constraint on the weights of both performance-driven evaluation and economic-driven evaluation. The constraints system are used to elicit the weights with the objective of respecting the maximum of constraints (see Program 1 below). This elicitation procedure is mandatory in case where the set of non-dominated materials is very large or in case of no consensus can be reached between the product designers when choosing manually the most preferred material. This procedure is illustrated on FIG. 3.

Program 1:

$$minimize \quad \sum_{i=1}^{P} \sigma_i$$

$$subject\ to: S(x) - S(y) \geq \delta - M.\sigma_i^{Pr}, \qquad \forall (x \succ_i y) \in P$$

$$S(x) = w_1.x_1 + w_2.x_2, \quad \forall\ x \in A$$

The Examples of the method which have been discussed above allow the following.

Given an engineering component with rigid (e.g. geometry, external forces, properties of stock material before processing, etc.) and soft requirements (e.g. mechanical properties, physical properties, economic criteria, etc.), multiple materials can be used to create it. Three families of properties are involved in order to select the most suitable material: the performance properties, the economical properties and finally the product designers' preferences. It is desired to ensure the feasibility of the decision as well as the gain of the product designers' confidence. In order to enhance the applicability of this invention, the examples consider a two level decision making situation: in the first level (performance-driven evaluation), the method builds an evaluation model that accesses the intrinsic performance of the candidate materials and associates a performance compatibility index to each material. In the second level (cost-driven evaluation), the method evaluates the economic contribution of the candidate materials and an economic prioritization index is associated to each material. As a result, the method analyzes the tradeoff between the performance-driven and the cost-driven evaluations. Technically, the method considers the material selection problem that involves the following features: numerical and nonnumerical requirements, user and multiple user preferences, an integrated normalization technique, capability to handle large dataset, latent requirements preference, and an interaction structure is defined on the evaluation requirements.

The examples of the method use a methodology to handle the materials selection problem by considering the evaluation materials according to performance properties and economic properties using a multicriteria sorting model. The examples use the Non-Compensatory Sorting model (NCS) to assign to each material a prioritization index on both performance and economic dimensions. Used NCS models (one model to access the performance evaluation and a model to access the economic evaluation) are learned interactively according to the preferences of a group of product designers. A voting rule is involved to build the consensus among different point of views and therefore learn such collective NCS models. After computing the performance compatibility indexes and the economic prioritization indexes, the Pareto front, which implies non-dominated materials, is displayed, and a decision support tool is provided to support the product designers committee choosing the most preferred material.

The examples allow the combination of both evaluation systems i.e. performance-driven evaluation and economic driven evaluation with the fact of considering them in the same devise. Considering the product designers preferences when constructing the two evaluation models ensures the feasibility of the decision as well as the gain of the product designers' confidence and ovoid the black box problem. Existing solutions that consider the user preference such as AHP, ANP and Electre focus on representing the preferences of a single product designer. In contrast, decisions made in this type of applications are not generally the responsibility of a unique decision maker but a group of decision makers. The method generalizes existing solutions in this direction by providing decision support tools that involve of committee of product designers. Regarding material qualifications, as summarized above, the method provides a solution that handles different types of evaluations such as latent monotone evaluations, single peaked and single valley evaluations. The consideration of these types of criteria in these examples of the method is coupled with the elicitation of its patterns e.g., the method learns evaluation system for materials and the parameters of these criteria simultaneously, which may be useful for a future use of the solution. In the proposed solution, the method adopts the sorting method NCS to evaluate materials according to performance and economic properties. With NCS model, the method considers interactions between evaluation properties and one of its specificity is to account for the alternative evaluations in an ordinal perspective avoiding compensation and enables to deal meaningfully with qualitative data. Finally, the provided SAT/MaxSAT based solution through the method is investigated to be computationally efficient and eventually be able to solve problems with large datasets.

It is now discussed an application of examples of the method as a designers-oriented decision support system for materials selection for knee prosthesis.

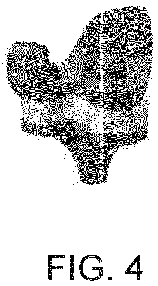

It is here considered the situation where a manufacturer of orthopedic implants and instruments seeks to expand its field of work by constructing knee prosthesis. FIG. 4 illustrates such a prothesis. The scientific council of the company decides to select the most compatible material for his new product. In this example, metallic biomaterials (biologically compatible materials) that could potentially be used are considered as candidate materials. The selection process involves multiple experts and designers who have diverse experiences and may be conflicting point of views. This amount to choose the most compatible material and aligned with the scientific council members choices. Given the growing activity of the company, several new products will be manufactured in the coming years. Hence, the need to automate this selection process and develop a decision support aid system. The decision support aid system relies on the method.

The steps followed in selecting the most suitable material for the knee prosthesis product are detailed below:

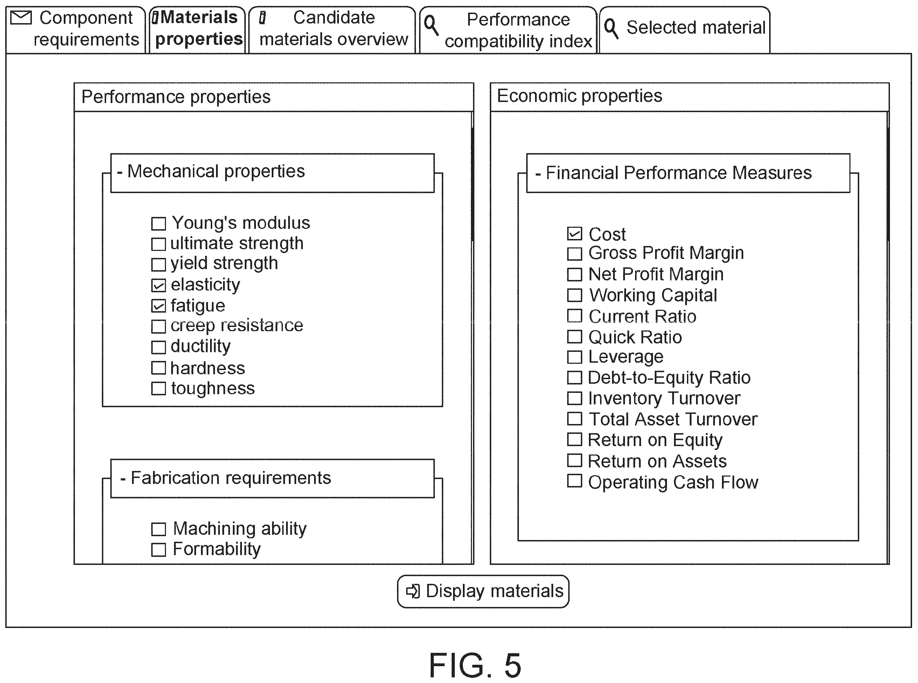

Step 1: Criteria selection (illustrated on FIG. 5): the designers start by choosing the performance and economic properties, which will be used to evaluate the candidate materials. In the example illustrated on FIG. 5, eight performance properties including latent performances and one economic property are selected. In this case, gain, cost and target value represented by single peaked values.

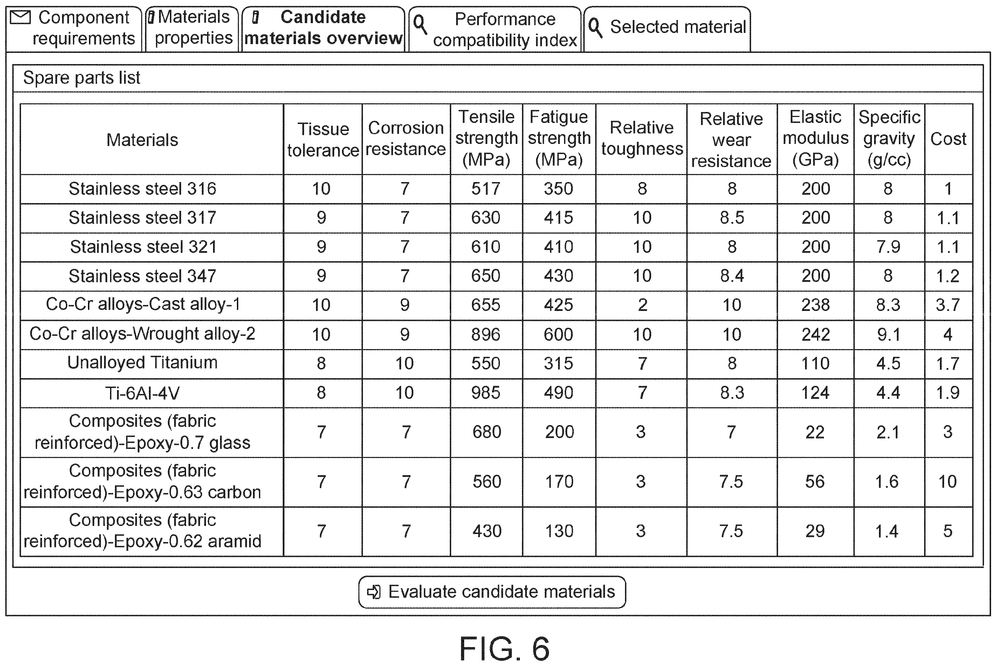

Step 2: Performance Table (illustrated on FIG. 6): the performance table is presented (displayed), which groups together the evaluations of materials according to the performance properties and the cost, which is the unique selected economic property

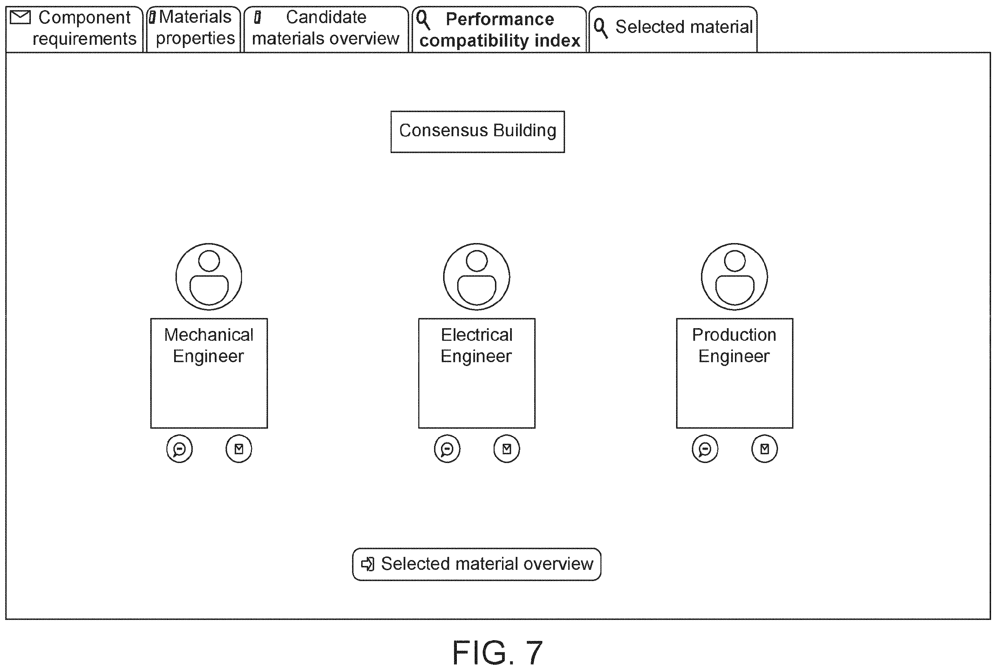

Step 3: Construct a performance-driven evaluation model on the candidate materials: At this stage, the objective is to build an evaluation model that will be used to associate each material with a performance compatibility index. The construction of this evaluation model involves three designers and the objective is to learn the model from their preferences (illustrated on FIG. 7).

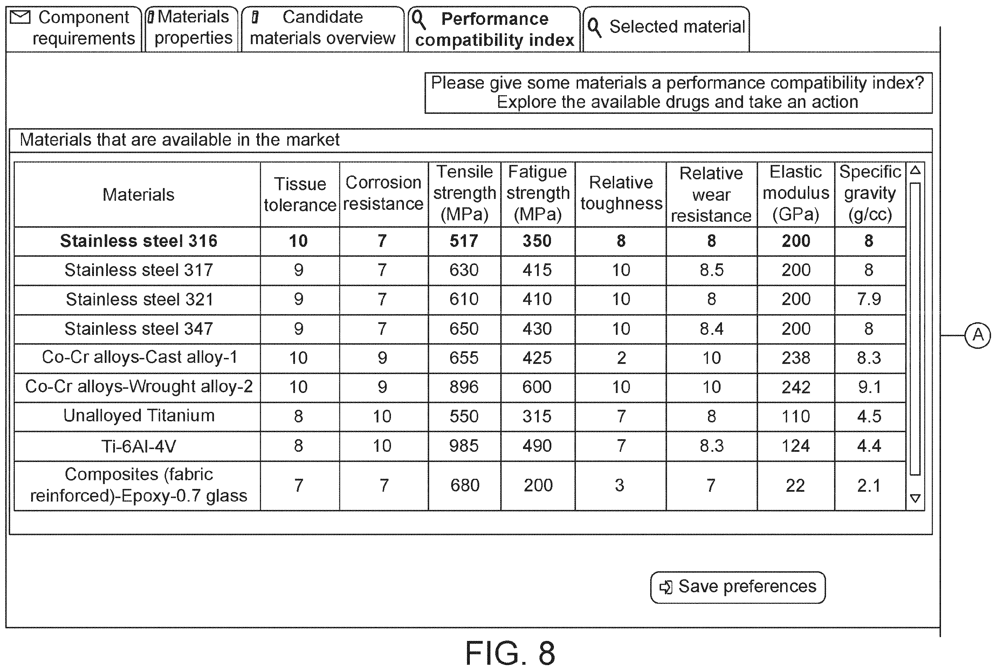

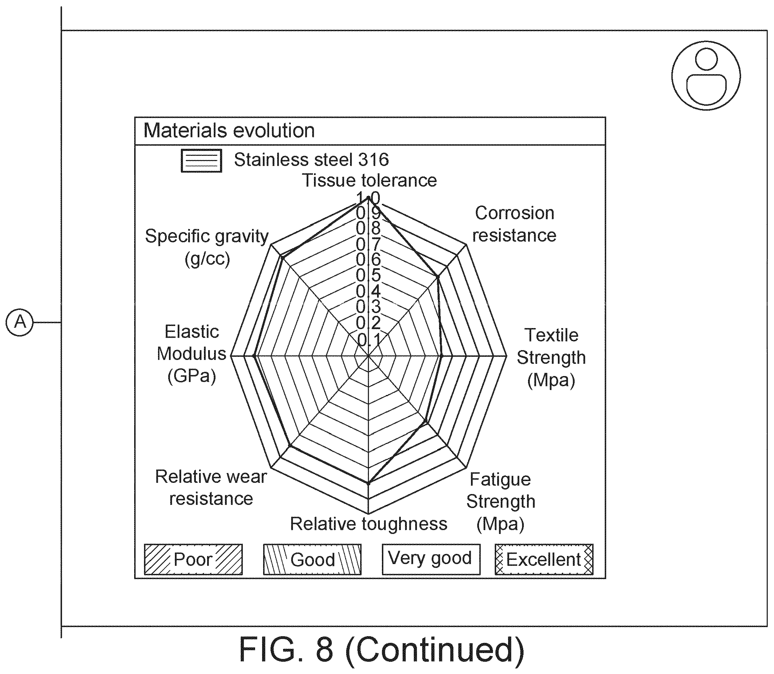

Step 4: Then, each designer is invited to express his preferences on a few candidate materials called hereafter reference materials (illustrated on FIG. 8).

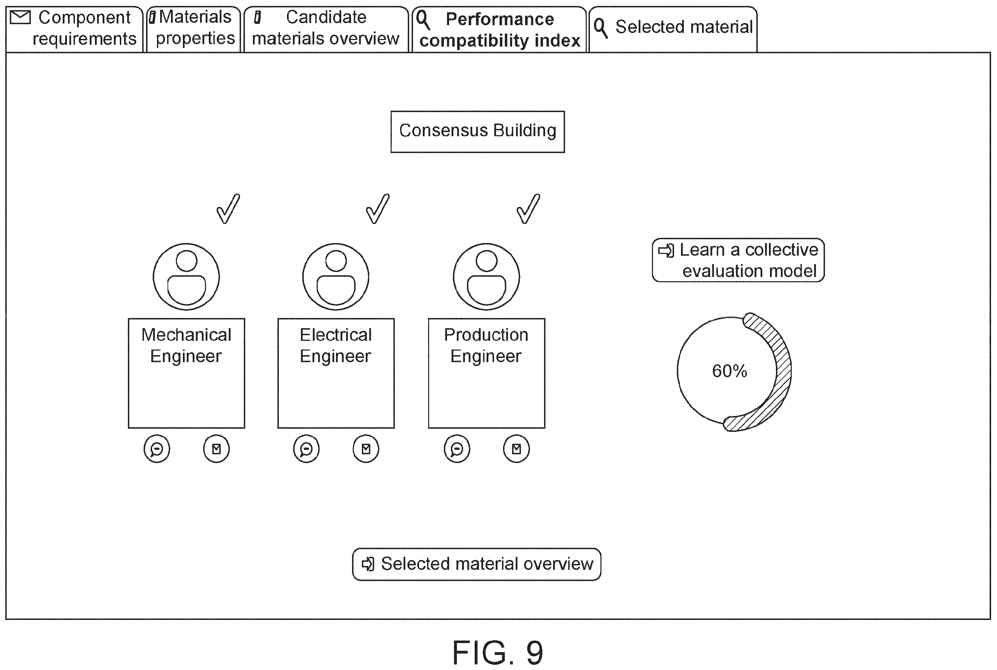

Step 5: After the preference elicitation phase, a collective model is constructed from the preferences provided by the three designers. At this stage (illustrated on FIG. 9), a compatibility test is performed. In the case where the preferences of the three designers are consistent, a learning formulation is used to generate a compatible evaluation model. Otherwise, the method proceeds interactively with the three designers to revise their preferences in order to build a consensus.

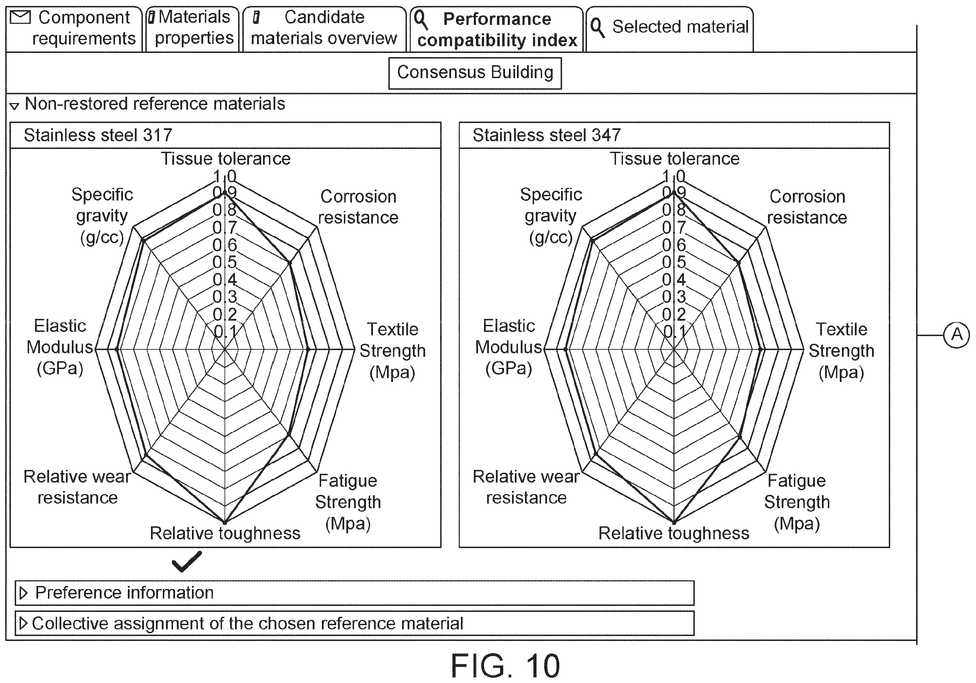

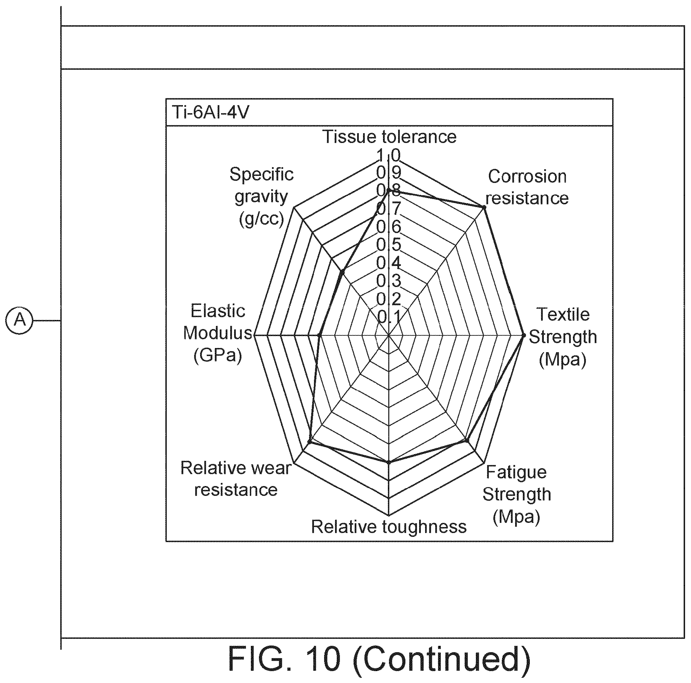

Step 6: The interactive procedure used to revise the designers preferences starts by generating reference materials that represent the inconsistency source. Once these materials are generated, in each iteration, the method randomly takes a material and generate the associated performance compatibility indexes, which remove the associated inconsistency (illustrated on FIG. 10).

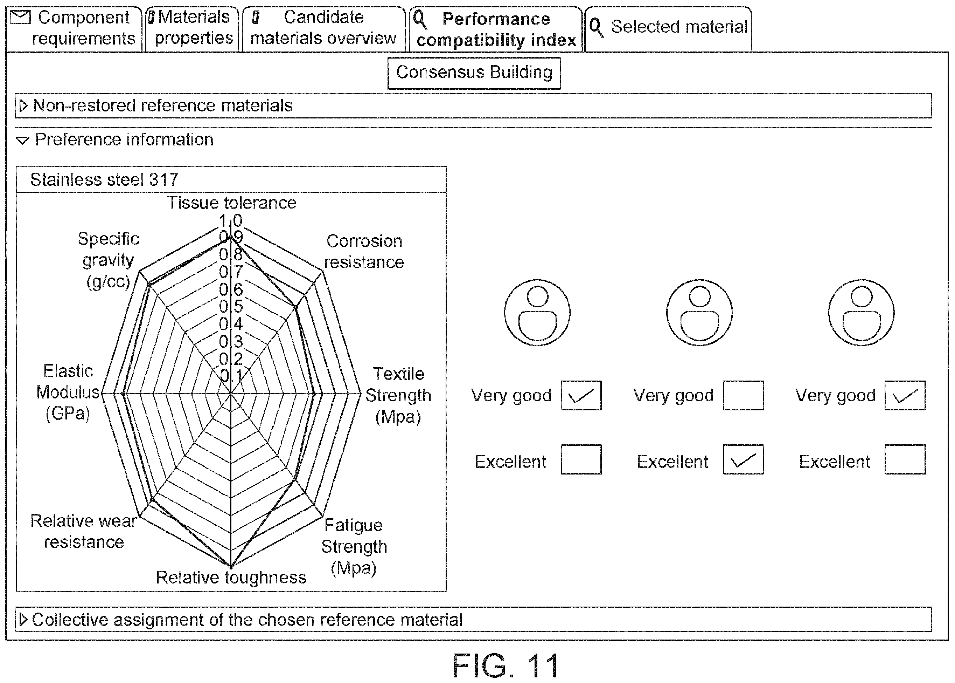

Step 7: Then, the designers are asked to associate the desired performance compatibility index with this material among possible ones (illustrated on FIG. 11).

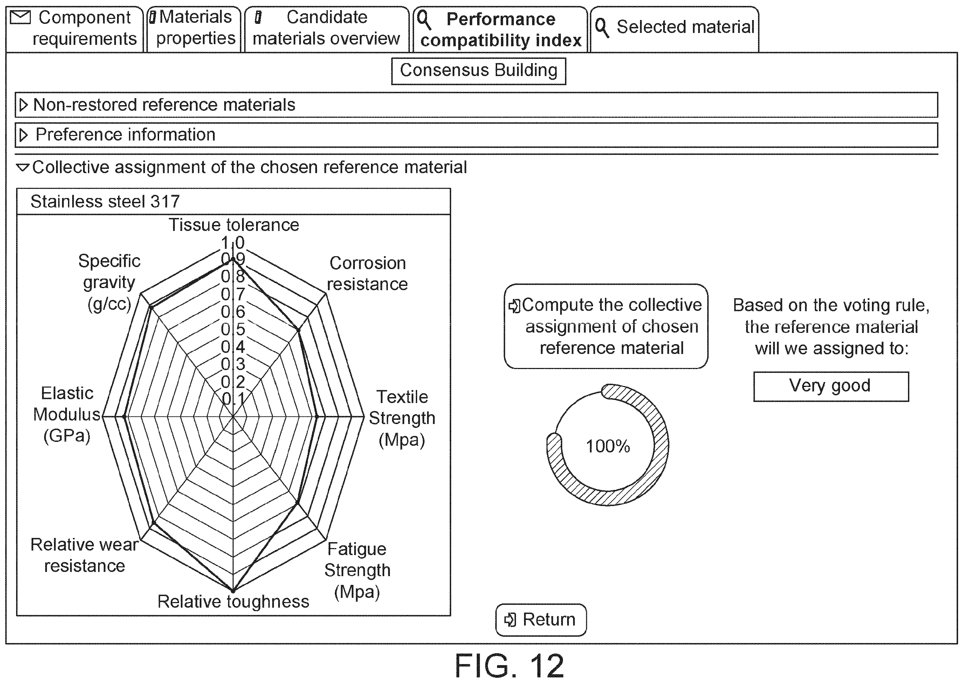

Step 8: Finally, based on a voting rule, the method deduces the collective performance compatibility index of the material from the preferences of the three designers (illustrated on FIG. 12).

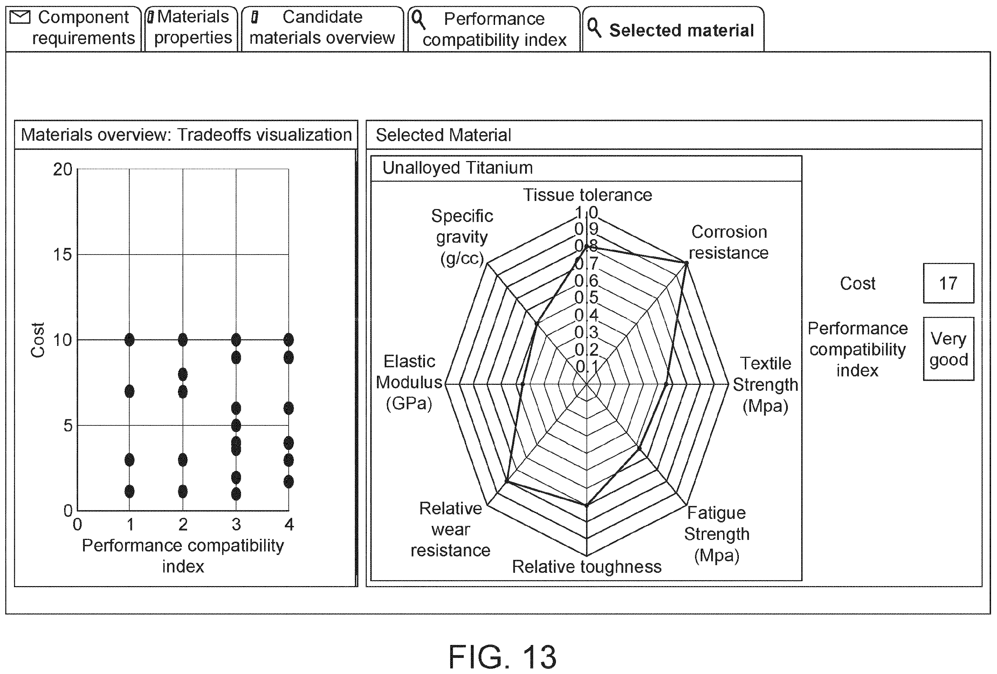

Step 9: The preference revision process is repeated until the preferences of the designers become consistent. In this case, a collective evaluation model can be learned from these preferences and this model will be used to associate each material with a performance compatibility index. In the last stage the method presents the trade-offs between a performance compatibility index and the cost for each candidate material. The selected material is associated to a pareto optimal solution (illustrated on FIG. 13).

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 14 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

**Claims**

1.  A computer-implemented method for designing a manufacturing product, the method comprising:

    - obtaining, as inputs:

        • data specifying a set of materials for manufacturing the product;
        • a set of use and/or manufacturing constraints for the manufacturing product, the constraints including rigid constraints and soft constraints; and
        • specifications indicating an extent of compatibility of one or more reference materials with the constraints, the one or more reference materials being one or more materials of the set of materials, the specifications including, for each reference material, an overall score of the material with the constraints;
        • for each material of the set of materials and each constraint, a score of the material on the constraint;

    - determining an optimal subset of the set of materials for manufacturing the product, the determining including classifying the materials of the set of material with respect to compatibility with the constraints and based on the specifications, the classification aiming at satisfying the rigid constraints and maximizing satisfaction of the soft constraints, the classification processing the provided scores to classify the materials of the set of materials using the specifications as a model to learn from;
- selecting one or more materials within the determined optimal subset; and
- using the selected one or more materials for manufacturing the product,
wherein the classification comprises learning a Multiple Criteria Decision Aiding sorting model configured to take as input a set of materials and to output an optimal subset of materials, the learning being based on the set of materials, on the constraints, and on the specifications,
wherein the specifications forms a learning set of the model,
wherein the model includes one or more Non-Compensatory Sorting (NCS) models.

2. The method of claim 1, wherein the learning comprises encoding learning clauses based on the constraints, the encoding using a SAT-based encoding.

3. The method of any one of claims 1 to 2, wherein the specifications comprise incompatible specifications, and the learning includes finding a compromise between the incompatible specifications.

4. The method of claim 3, wherein the learning comprises encoding learning clauses based on the constraints, the encoding using a MaxSAT-based encoding.

5. The method of claim 3 or 4, wherein finding a compromise comprises iteratively modifying the learning set until reaching an extent of compatibility between the specifications.

6. The method of any one of claims 3 to 5, wherein the incompatible specifications are obtained from different users.

7. The method of any one of claims 1 to 6, wherein the specifications is obtained from one or more users.

8. The method of any one of claims 1 to 7, wherein one or more constraints are latent constraints, a latent constraint being a constraint for which it is not known whether such constraint is to be maximized, minimized, or minimized below or above a peak, or maximized above or below a peak.

9. A computer program comprising instructions which, when executed on a computer system, causes the computer system to carry out the method of any one of claims 1 to 8.

10. A computer-readable data storage medium having recorded thereon the computer program of claim 9.

11. A computer system comprising a processor coupled to a memory, the memory having recorded thereon the computer program of claim 9.

**Patentansprüche**

1. Computerimplementiertes Verfahren zum Entwurf eines Fertigungserzeugnisses, wobei das Verfahren Folgendes umfasst:

- Erhalten von Eingaben:

• Daten, die einen Satz von Materialien für die Fertigung des Erzeugnisses spezifizieren;
• einen Satz von Nutzungs- und/oder Fertigungsbeschränkungen für das Fertigungserzeugnis, wobei die Beschränkungen starre Beschränkungen und flexible Beschränkungen umfassen; und
• Spezifikationen, die einen Grad der Kompatibilität eines oder mehrerer Referenzmaterialien mit den Beschränkungen angeben, wobei das eine oder die mehreren Referenzmaterialien ein oder mehrere Materialien des Satzes von Materialien sind, wobei die Spezifikationen für jedes Referenzmaterial eine Gesamtbewertung des Materials mit Bezug auf die Beschränkungen beinhalten;
• für jedes Material des Satzes von Materialien und jede Beschränkung eine Bewertung des Materials mit Bezug auf die Beschränkung;

- Bestimmen eines optimalen Teilsatzes des Satzes von Materialien für die Fertigung des Erzeugnisses, wobei das Bestimmen das Klassifizieren der Materialien des Satzes von Materialien mit Bezug auf die Kompatibilität mit den Beschränkungen und basierend auf den Spezifikationen beinhaltet, wobei die Klassifizierung auf die Erfüllung der starren Beschränkungen und die Maximierung der Erfüllung der flexiblen Beschränkungen abzielt, wobei die Klassifizierung die bereitgestellten Bewertungen verarbeitet, um die Materialien des Satzes von Materialien unter Verwendung der Spezifikationen als Lernmodell zu klassifizieren,

- Auswählen eines oder mehrerer Materialien innerhalb des bestimmten optimalen Teilsatzes; und
- Verwenden des/der ausgewählten einen oder mehreren Materalen zur Fertigung des Erzeugnisses,

wobei das Klassifizieren das Lernen eines Multiple Criteria Decision Aiding-Sortiermodells umfasst, das konfiguriert ist, um als Eingabe einen Satz von Materialien zu verwenden und einen optimalen Teilsatz von Materialien auszugeben, wobei das Lernen auf dem Satz von Materialien, auf den Beschränkungen und auf den Spezifikationen basiert,

wobei die Spezifikationen einen Lernsatz des Modells bilden,

wobei das Modell ein oder mehrere Non-Compensatory Sorting (NCS)-Modelle beinhaltet.

2. Verfahren nach Anspruch 1, wobei das Lernen das Kodieren von Lernklauseln basierend auf den Einschränkungen umfasst, wobei die Kodierung eine SAT-basierte Kodierung verwendet.

3. Verfahren nach einem der Ansprüche 1 bis 2, wobei die Spezifikationen inkompatible Spezifikationen umfassen und das Lernen das Finden eines Kompromisses zwischen den inkompatiblen Spezifikationen beinhaltet.

4. Verfahren nach Anspruch 3, wobei das Lernen das Kodieren von Lernklauseln basierend auf den Einschränkungen umfasst, wobei das Kodieren eine MaxSAT-basierte Kodierung verwendet.

5. Verfahren nach Anspruch 3 oder 4, wobei das Finden eines Kompromisses das iterative Modifizieren des Lernsatzes umfasst, bis ein Grad der Kompatibilität zwischen den Spezifikationen erreicht ist.

6. Verfahren nach einem der Ansprüche 3 bis 5, wobei die inkompatiblen Spezifikationen von verschiedenen Benutzern erhalten werden.

7. Verfahren nach einem der Ansprüche 1 bis 6, wobei die Spezifikationen von einem oder mehreren Benutzern erhalten werden.

8. Verfahren nach einem der Ansprüche 1 bis 7, wobei eine oder mehrere Beschränkungen latente Beschränkungen sind, wobei eine latente Beschränkung eine Beschränkung ist, bei der nicht bekannt ist, ob eine derartige Beschränkung maximiert, minimiert oder unterhalb bzw. oberhalb einer Spitze minimiert oder oberhalb bzw. unterhalb einer Spitze maximiert werden soll.

9. Computerprogramm, umfassend Anweisungen, die, wenn sie auf einem Computersystem ausgeführt werden, das Computersystem veranlassen, das Verfahren nach einem der Ansprüche 1 bis 8 durchzuführen.

10. Computerlesbares Datenspeichermedium, auf dem das Computerprogramm nach Anspruch 9 aufgezeichnet ist.

11. Computersystem, umfassend einen Prozessor, der mit einem Speicher gekoppelt ist, wobei auf dem Speicher das Computerprogramm nach Anspruch 9 aufgezeichnet ist.

**Revendications**

1. Procédé mis en œuvre par ordinateur pour concevoir un produit de fabrication, le procédé comprenant le fait de :

- obtenir, en tant qu'entrées :

• des données spécifiant un ensemble de matériaux pour la fabrication du produit ;
• un ensemble de contraintes d'utilisation et/ou de fabrication pour le produit de fabrication, les contraintes comprenant des contraintes rigides et des contraintes souples ; et
• des spécifications indiquant un degré de compatibilité d'un ou plusieurs matériaux de référence avec les contraintes, le ou les matériaux de référence étant un ou plusieurs matériaux de l'ensemble de matériaux, les spécifications comprenant, pour chaque matériau de référence, un score général du matériau par rapport aux contraintes ;

• pour chaque matériau de l'ensemble de matériaux et chaque contrainte, un score du matériau par rapport à la contrainte ;

- déterminer un sous-ensemble optimal de l'ensemble de matériaux pour la fabrication du produit, la détermination comprenant le fait de classer les matériaux de l'ensemble de matériaux en fonction de leur compatibilité avec les contraintes et sur la base des spécifications, le classement visant à satisfaire les contraintes rigides et à maximiser la satisfaction des contraintes souples, le classement traitant les scores fournis pour classer les matériaux de l'ensemble de matériaux en utilisant les spécifications comme modèle d'apprentissage ;
- sélectionner un ou plusieurs matériaux dans le sous-ensemble optimal déterminé ; et
- utiliser le ou les matériaux sélectionnés pour fabriquer le produit de fabrication,
dans lequel le classement comprend le fait d'apprendre un modèle de tri d'aide multicritère à la décision configuré pour prendre en entrée un ensemble de matériaux et pour fournir en sortie un sous-ensemble optimal de matériaux, l'apprentissage étant basé sur l'ensemble de matériaux, sur les contraintes et sur les spécifications, dans lequel les spécifications forment un ensemble d'apprentissage du modèle,
dans lequel le modèle comprend un ou plusieurs modèles de tri non-compensatoire (NCS).

2. Procédé selon la revendication 1, dans lequel l'apprentissage comprend le fait de coder des clauses d'apprentissage sur la base des contraintes, le codage faisant appel à un codage basé sur SAT.

3. Procédé selon l'une quelconque des revendications 1 à 2, dans lequel les spécifications comprennent des spécifications incompatibles, et l'apprentissage comprend le fait de rechercher un compromis entre les spécifications incompatibles.

4. Procédé selon la revendication 3, dans lequel l'apprentissage comprend le fait de coder des clauses d'apprentissage sur la base des contraintes, le codage utilisant un codage basé sur MaxSAT.

5. Procédé selon la revendication 3 ou 4, dans lequel la recherche d'un compromis comprend le fait de modifier de manière itérative l'ensemble d'apprentissage jusqu'à atteindre un degré de compatibilité entre les spécifications.

6. Procédé selon l'une quelconque des revendications 3 à 5, dans lequel les spécifications incompatibles sont obtenues auprès de différents utilisateurs.

7. Procédé selon l'une quelconque des revendications 1 à 6, dans lequel les spécifications sont obtenues auprès d'un ou plusieurs utilisateurs.

8. Procédé selon l'une quelconque des revendications 1 à 7, dans lequel une ou plusieurs contraintes sont des contraintes latentes, une contrainte latente étant une contrainte pour laquelle on ne sait pas si cette contrainte doit être maximisée, minimisée, ou minimisée en dessous ou au-dessus d'un pic, ou maximisée au-dessus ou en dessous d'un pic.

9. Programme informatique comprenant des instructions qui, lorsqu'elles sont exécutées sur un système informatique, amènent le système informatique à mettre en œuvre le procédé selon l'une quelconque des revendications 1 à 8.

10. Support de stockage de données lisible par ordinateur sur lequel est enregistré le programme informatique de la revendication 9.

11. Système informatique comprenant un processeur couplé à une mémoire, sur laquelle mémoire est enregistré le programme informatique selon la revendication 9.

Component to be created

List of candidate materials

Identify the component rigid requirements

Identify the component soft requirements

Identify the performance properties

Evaluate materials on the component rigid requirements

Evaluate materials on the component soft requirements

Access materials on the performance properties

Computing SAT/MaxSAT formulation for learning an NCS model based on component rigid and soft requirements and performance properties

10

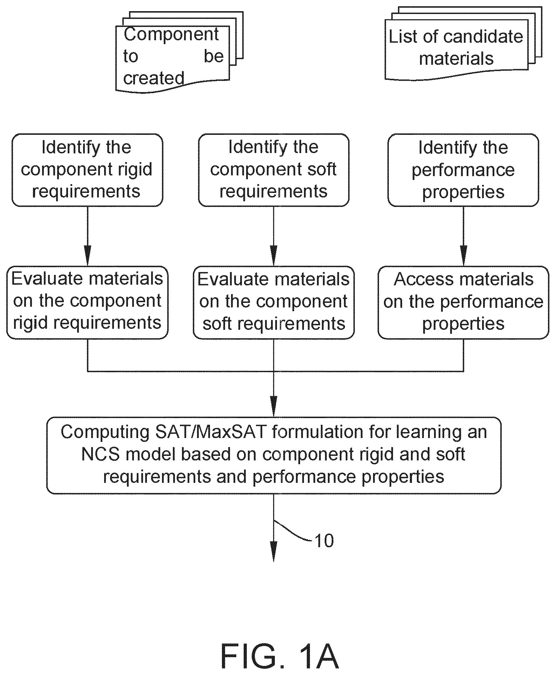

FIG. 1A

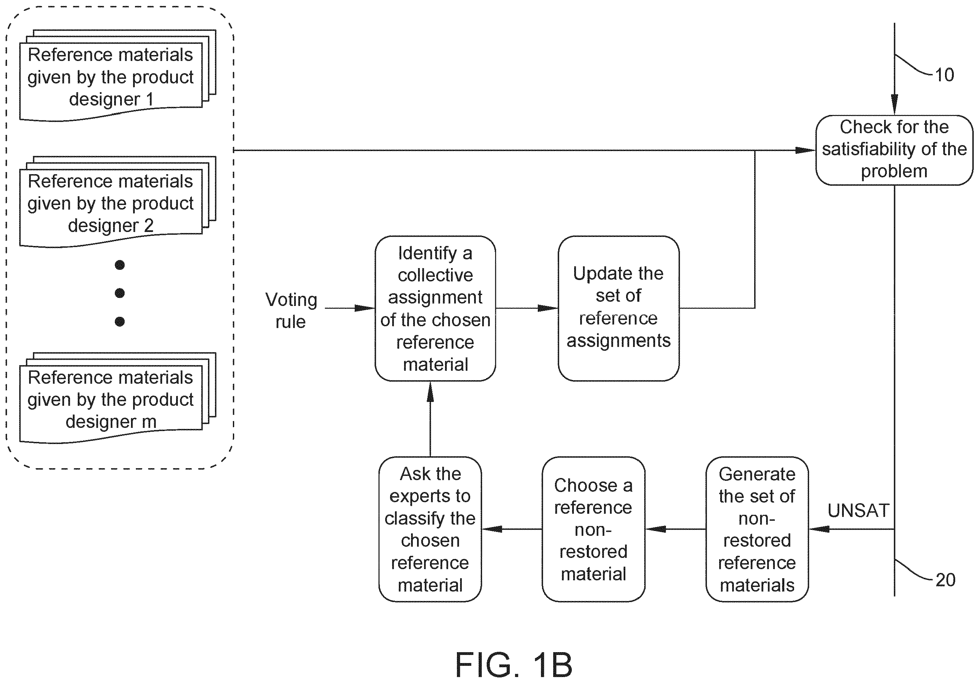

FIG. 1B

20 — SAT

Learning a collective NCS
model

SAT/MaxSAT learning
formulation

List of candidate
materials

The collective NCS
model

Attribute to each
candidate material
a performance
compatibility index

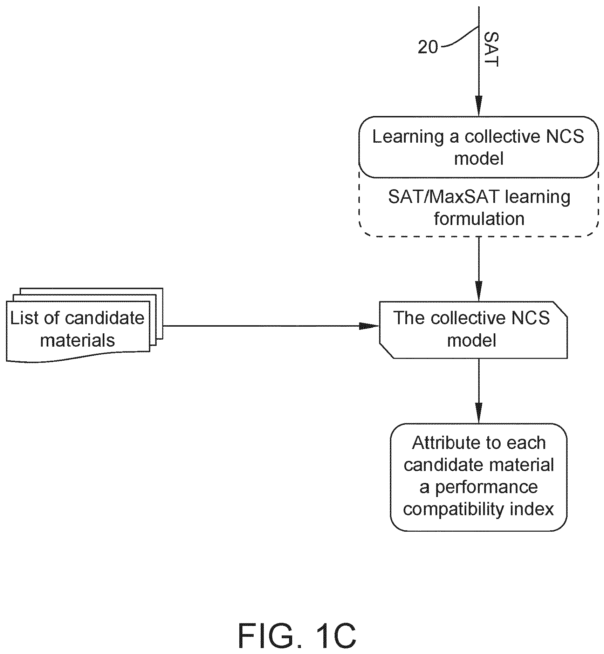

# FIG. 1C

Component to be created

List of candidate materials

| Identify the component rigid requirements | Identify the component soft requirements | Identify the economic properties |

| Evaluate materials on the component rigid requirements | Evaluate materials on the component soft requirements | Access materials on the economic properties |

Computing SAT/MaxSAT formulation for learning an NCS model based on component rigid and soft requirements and economic properties

30

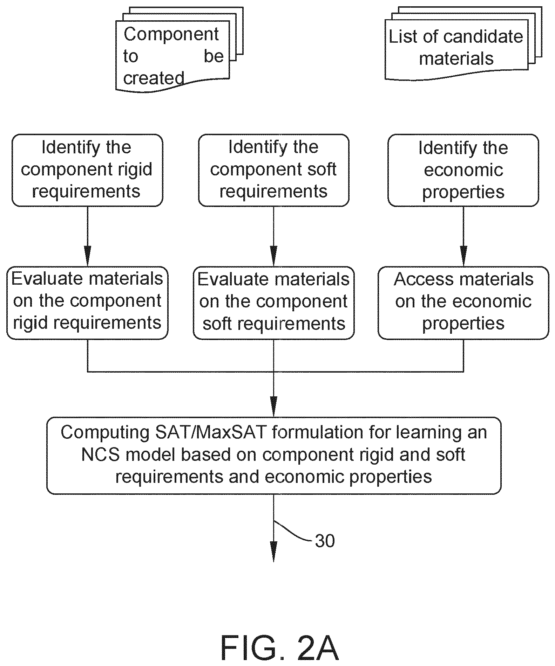

# FIG. 2A

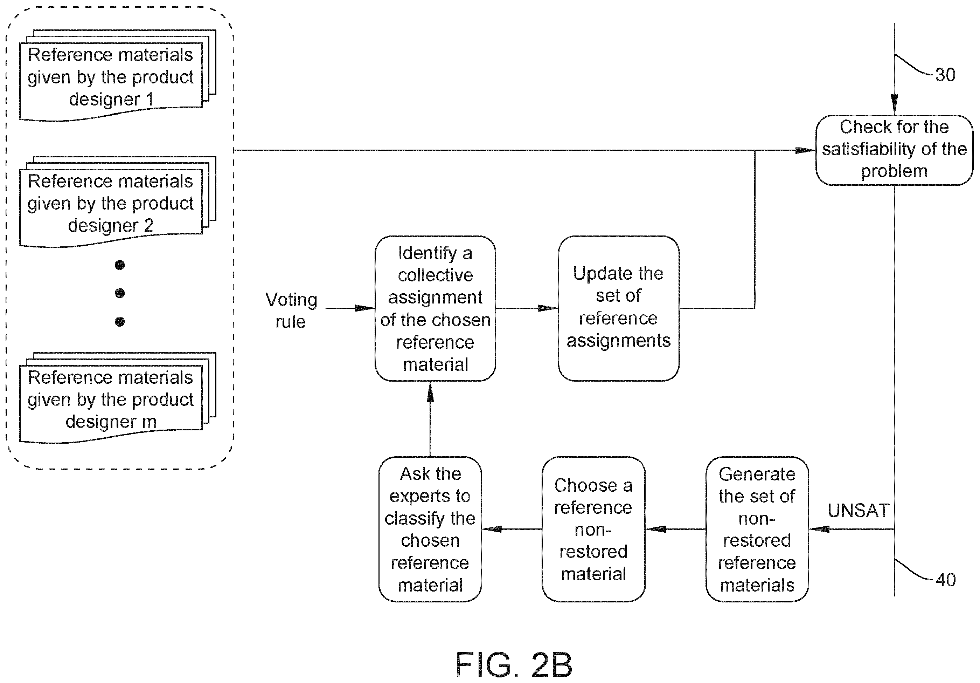

FIG. 2B

40 — SAT

Learning a collective NCS
model

SAT/MaxSAT learning
formulation

List of candidate
materials

The collective NCS
model

Attribute to each
candidate material
an economic
priorization index

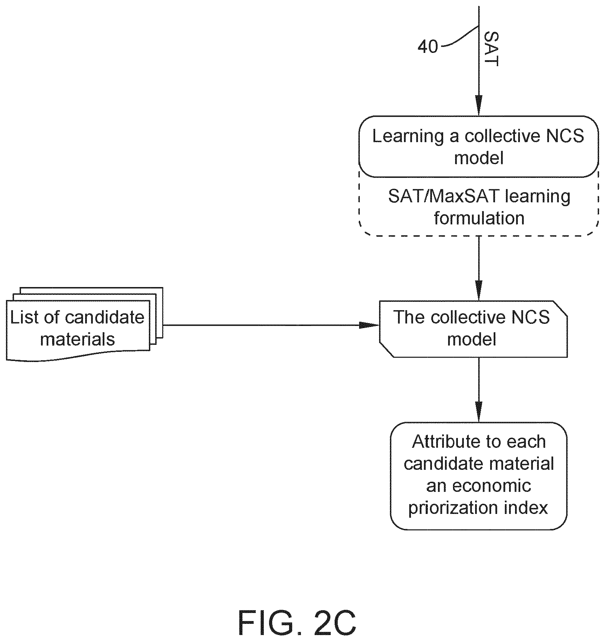

FIG. 2C

FIG. 3

FIG. 4

| ✉ Component requirements | ⓘ**Materials properties** | ⓘ Candidate materials overview | 🔍 Performance compatibility index | 🔍 Selected material |

**Performance properties**

**- Mechanical properties**

☐ Young's modulus
☐ ultimate strength
☐ yield strength
☑ elasticity
☑ fatigue
☐ creep resistance
☐ ductility
☐ hardness
☐ toughness

**- Fabrication requirements**

☐ Machining ability
☐ Formability

**Economic properties**

**- Financial Performance Measures**

☑ Cost
☐ Gross Profit Margin
☐ Net Profit Margin
☐ Working Capital
☐ Current Ratio
☐ Quick Ratio
☐ Leverage
☐ Debt-to-Equity Ratio
☐ Inventory Turnover
☐ Total Asset Turnover
☐ Return on Equity
☐ Return on Assets
☐ Operating Cash Flow

⏎ Display materials

FIG. 5

| ✉ Component requirements | 🗎 Materials properties | 🗎 **Candidate materials overview** | 🔍 Performance compatibility index | 🔍 Selected material |

| Spare parts list |

| Materials | Tissue tolerance | Corrosion resistance | Tensile strength (MPa) | Fatigue strength (MPa) | Relative toughness | Relative wear resistance | Elastic modulus (GPa) | Specific gravity (g/cc) | Cost |
|---|---|---|---|---|---|---|---|---|---|
| Stainless steel 316 | 10 | 7 | 517 | 350 | 8 | 8 | 200 | 8 | 1 |
| Stainless steel 317 | 9 | 7 | 630 | 415 | 10 | 8.5 | 200 | 8 | 1.1 |
| Stainless steel 321 | 9 | 7 | 610 | 410 | 10 | 8 | 200 | 7.9 | 1.1 |
| Stainless steel 347 | 9 | 7 | 650 | 430 | 10 | 8.4 | 200 | 8 | 1.2 |
| Co-Cr alloys-Cast alloy-1 | 10 | 9 | 655 | 425 | 2 | 10 | 238 | 8.3 | 3.7 |
| Co-Cr alloys-Wrought alloy-2 | 10 | 9 | 896 | 600 | 10 | 10 | 242 | 9.1 | 4 |
| Unalloyed Titanium | 8 | 10 | 550 | 315 | 7 | 8 | 110 | 4.5 | 1.7 |
| Ti-6Al-4V | 8 | 10 | 985 | 490 | 7 | 8.3 | 124 | 4.4 | 1.9 |
| Composites (fabric reinforced)-Epoxy-0.7 glass | 7 | 7 | 680 | 200 | 3 | 7 | 22 | 2.1 | 3 |
| Composites (fabric reinforced)-Epoxy-0.63 carbon | 7 | 7 | 560 | 170 | 3 | 7.5 | 56 | 1.6 | 10 |
| Composites (fabric reinforced)-Epoxy-0.62 aramid | 7 | 7 | 430 | 130 | 3 | 7.5 | 29 | 1.4 | 5 |

↻ Evaluate candidate materials

## FIG. 6

| ✉ Component requirements | 🗋 Materials properties | 🗋 Candidate materials overview | 🔍 **Performance compatibility index** | 🔍 Selected material |

Consensus Building

Mechanical Engineer

Electrical Engineer

Production Engineer

🗗 Selected material overview

FIG. 7

| Component requirements | Materials properties | Candidate materials overview | **Performance compatibility index** | Selected material |
|---|---|---|---|---|

Please give some materials a performance compatibility index?
Explore the available drugs and take an action

Materials that are available in the market

| Materials | Tissue tolerance | Corrosion resistance | Tensile strength (MPa) | Fatigue strength (MPa) | Relative toughness | Relative wear resistance | Elastic modulus (GPa) | Specific gravity (g/cc) |
|---|---|---|---|---|---|---|---|---|
| **Stainless steel 316** | **10** | **7** | **517** | **350** | **8** | **8** | **200** | **8** |
| Stainless steel 317 | 9 | 7 | 630 | 415 | 10 | 8.5 | 200 | 8 |
| Stainless steel 321 | 9 | 7 | 610 | 410 | 10 | 8 | 200 | 7.9 |
| Stainless steel 347 | 9 | 7 | 650 | 430 | 10 | 8.4 | 200 | 8 |
| Co-Cr alloys-Cast alloy-1 | 10 | 9 | 655 | 425 | 2 | 10 | 238 | 8.3 |
| Co-Cr alloys-Wrought alloy-2 | 10 | 9 | 896 | 600 | 10 | 10 | 242 | 9.1 |
| Unalloyed Titanium | 8 | 10 | 550 | 315 | 7 | 8 | 110 | 4.5 |
| Ti-6Al-4V | 8 | 10 | 985 | 490 | 7 | 8.3 | 124 | 4.4 |
| Composites (fabric reinforced)-Epoxy-0.7 glass | 7 | 7 | 680 | 200 | 3 | 7 | 22 | 2.1 |

(A)

⏎ Save preferences

FIG. 8

Materials evolution

Stainless steel 316

Tissue tolerance

Corrosion resistance

Textile Strength (Mpa)

Fatigue Strength (Mpa)

Relative toughness

Relative wear resistance

Elastic Modulus (GPa)

Specific gravity (g/cc)

Poor | Good | Very good | Excellent

FIG. 8 (Continued)

| ✉ Component requirements | ℹ Materials properties | ℹ Candidate materials overview | 🔍 **Performance compatibility index** | 🔍 Selected material |

Consensus Building

Mechanical Engineer

Electrical Engineer

Production Engineer

🗗 Learn a collective evaluation model

60%

🗗 Selected material overview

FIG. 9

FIG. 10

FIG. 10 (Continued)

| ✉ Component requirements | 𝑖 Materials properties | 𝑖 Candidate materials overview | 🔍 **Performance compatibility index** | 🔍 Selected material |

Consensus Building

▷ Non-restored reference materials

▽ Preference information

Stainless steel 317

Very good ☑    Very good ☐    Very good ☑

Excellent ☐    Excellent ☑    Excellent ☐

▷ Collective assignment of the chosen reference material

FIG. 11

FIG. 12

EP 4 312 152 B1

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **M. IPEK**. An expert system based material selection approach to manufacturing. *Materials and Design*, 2013, vol. 47, 331-340
- **A. TLILI**. Learning non-compensatory sorting models using efficient SAT /MaxSAT formulations. *European Journal of Operational Research*
- **MINOUNGOU**. Learning MR-Sort Models from Non-Monotone Data. *arXiv:2107.09668v1*, 20 July 2021
- **ALI JAHAN** ; **KEVIN L. EDWARDS** ; **MARJAN BAHRAMINASAB**. Materials selection in the context of design problem-solving. *Butterworth-Heinemann*, 2016, 25-40
- **JAHAN** ; **ALI** ; **KEVIN L EDWARDS**. Multi-Criteria Decision Analysis for Supporting the Selection of Engineering Materials in Product Design. Oxford: Elsevier Science & Technology, 2013
- Overview of the Materials Selection Process. **DIETER, G.E.** ASM Metals Handbook, Materials Selection and Design. ASM International, Materials Park, 1997
- **JAHAN** ; **ALI** ; **EDWARDS** ; **KEVIN** ; **BAHRAMINASAB** ; **MARJAN**. *The importance of decision support in materials selection"*, 2016
- **B. ROY**. Multicriteria Methodology for Decision Aiding. Kluwer Academic, 1996
- **M. KHALILZADEH** ; **A. KARAMI** ; **ALBORZ HAJIKHANI**. The multi-objective supplier selection problem with fuzzy parameters and solving the order allocation problem with coverage". *Journal of Modelling in Management*, 2020, vol. 15, 705-725
- **ANA PAULA HENRIQUES DE GUSMÃO** ; **C. MEDEIROS**. A model for selecting a strategic information system using the fitradeoff'. *Mathematical Problems in Engineering*, 2016, 1-7
- **O. SOBRIE** ; **M. E. A. LAZOUNI** ; **S. MAHMOUDI** ; **V. MOUSSEAU** ; **M. PIRLOT**. A new decision support model for preanesthetic evaluation. *Computer Methods and Programs in Biomedicine*, 2016, vol. 133, 183-193
- **BOUYSSOU, D** ; **MARCHANT, T.** An axiomatic approach to noncompensatory sorting methods in MCDM, I: the case of two categories. *European Journal of Operational Research*, 2007, vol. 178 (1), 217-245
- **BOUYSSOU, D** ; **MARCHANT, T**. An axiomatic approach to noncompensatory sorting methods in MCDM, II: more than two categories. *European Journal of Operational Research*, 2007, vol. 178 (1), 246-276
- Aide multicritère à la décision dans le cadre de la problématique du tri: méthodes et applications. **YU, W**. Ph.D. thesis. LAMSADE, Université Paris Dauphine, 1992
- **BELAHCENE, K** ; **LABREUCHE, C** ; **MAUDET, N.** ; **MOUSSEAU, V** ; **OUERDANE, W**. An efficient SAT formulation for learning multiple criteria non-compensatory sorting rules from examples. *Computers & Operations Research*, 2018, vol. 97, 58-71
- *Mathematical Programming*, 1971, vol. 1, 366-375